# EUROPEAN PATENT SPECIFICATION

(11) **EP 4 239 989 B1**
(45) Date of publication and mention of the grant of the patent: **19.03.2025**
(21) Application number: 23705934.0
(22) Date of filing: 12.01.2023
(51) Int. Cl.: H04M 1/02, F16C 11/04, G06F 1/16

(54) **HINGE AND FOLDABLE ELECTRONIC DEVICE INCLUDING SAME**
SCHARNIER UND KLAPPBARE ELEKTRONISCHE VORRICHTUNG DAMIT
CHARNIÈRE ET DISPOSITIF ÉLECTRONIQUE PLIABLE LA COMPRENANT

(30) Priority: 12.01.2022 KR 20220004904; 04.02.2022 KR 20220015113
(43) Date of publication of application: 06.09.2023
(73) Proprietor: Samsung Electronics Co., Ltd., Suwon-si, Gyeonggi-do 16677 (KR)
(72) Inventor: PARK, Joongkyung, Suwon-si, Gyeonggi-do 16677 (KR)
(74) Representative: HGF
(86) International application number: PCT/KR2023/000564
(87) International publication number: WO 2023/136622

(56) References cited:
- KR-A- 20180 122 210
- KR-A- 20210 048 022
- KR-A- 20210 102 527
- KR-A- 20210 146 763
- US-A1- 2018 210 511

## Description

### [Technical Field]

Various embodiments disclosed in the document relate to a foldable electronic device and, more particularly, to a foldable electronic device including a hinge.

### [Background Art]

Electronic devices require a small profile for portability and require a large display area in order to provide a lot of information to users. In order to reconcile a small profile with a large display area of an electronic device, various form factors such as a foldable electronic device equipped with a flexible display have been used deviating from the existing rectangular bar-shaped form factor. An electronic device having a form factor such as a foldable display may include a foldable enclosure folded or unfolded around at least one hinge for folding or unfolding a flexible display.

For the convenience of use and various uses of a foldable electronic device, for example, folding or unfolding of a foldable enclosure may be stopped at an arbitrary folding angle in order to enable a foldable electronic device to be cradled and used in a partially folded state. In addition, for the convenience of a user, a foldable electronic device may provide tactile feedback by applying a reaction force to a user at a specific angle, for example, at an angle at which the foldable electronic device is completely folded or completely unfolded.

KR 2021 0146763 A relates to structure of arm and structure of hinge including the same and electronic device including the same. Disclosed is an electronic device comprising a hinge structure comprising an arm structure. The arm structure comprises: an arm body; a first cam disposed on one side of the arm body, including a first hole wherein at least a part of a rotation axis used for a folding operation of the foldable electronic device is inserted, and wherein mountains and valleys are formed around the first hole; a second cam disposed on the same axis as the one side of the arm body side by side, spaced apart from the first cam, including a second hole wherein at least a part of the rotation axis is inserted, and wherein mountains and valleys are formed around the second hole; and a connection unit disposed on another side of the arm body and fastened to a rotation unit used for rotation of the foldable electronic device.

KR 2021 0048022 A relates to a foldable display device and hinge device for the same. Disclosed are a foldable display device and a hinge device therefor. The foldable display device includes: a display panel including a foldable display area; a first panel support member overlapping a first area of the display panel to support the display panel; a second panel support member overlapping a second area of the display panel to support the display panel; and a hinge device coupled to the first panel support member and the second panel support member to guide folding and unfolding of the display panel based on two virtual rotation axes.

### [Disclosure of Invention]

### [Technical Problem]

A free stop and/or a detent function of a foldable electronic device may be implemented by a friction element and/or a cam structure included in a hinge. However, in case that the sizes of the friction element and the cam are reduced in order to reduce the size of the foldable electronic device, the stress, which is applied to the friction element and the cam by the folding and unfolding operation of the foldable electronic device, increases, and thus the hinge may be damaged.

Various embodiments disclosed in the document may provide a foldable electronic device which is capable of reducing the risk of damage thereof at the time of folding and unfolding operations and in which a free stop and/or a detent function is implemented in spite of a small size so as to improve user convenience.

### [Solution to Problem]

The scope of protection conferred is determined from the claims.

### [Advantageous Effects of Invention]

According to various embodiments disclosed in the document, provided is a foldable electronic device in which the direction of a force applied by a hinge actuator is changed to the direction of a pressing surface of a force transmission member and thus the force transmission member transmits a frictional force and detent torque to a rotation guide of a hinge leaf, thereby implementing a free stop and a detent function while having a reduced sized and a reduced risk of damage.

### [Brief Description of Drawings]

In connection with descriptions of the drawings, same or similar reference numerals will be used to refer to same or similar elements.
FIG. 1 is a block diagram of an electronic device in a network environment according to various embodiments.
FIG. 2A is a view showing an unfolded state of an electronic device according to various embodiments of the disclosure.
FIG. 2B is a view showing a folded state of the electronic device in FIG. 2A according to various embodiments of the disclosure.
FIG. 2C is an exploded perspective view of an electronic device 100 according to various embodiments of the disclosure.
FIG. 3 is a plan view showing a foldable enclosure and a hinge of a foldable electronic device according to various embodiments of the disclosure.
FIG. 4A is a perspective view showing an unfolded state of a hinge according to various embodiments of the disclosure.
FIG. 4B is a perspective view showing a folded state of a hinge according to various embodiments of the disclosure.
FIG. 4C is an exploded perspective view of a hinge according to various embodiments of the disclosure.
FIG. 4D is a side view of a hinge according to various embodiments of the disclosure.
FIG. 4E is a cross-sectional view of a hinge according to various embodiments of the disclosure.
FIG. 4F is a cross-sectional view of a hinge seen in another direction according to various embodiments of the disclosure.
FIG. 5A is a perspective view showing a hinge actuator of a hinge according to various embodiments of the disclosure.
FIG. 5B is an exploded perspective view showing a hinge actuator of a hinge according to various embodiments of the disclosure.
FIG. 6A is a perspective view showing a hinge base and a force transmission member according to various embodiments of the disclosure.
FIG. 6B is a cross-sectional view showing a hinge base and a force transmission member according to various embodiments of the disclosure.
FIG. 7A is a side view showing a hinge leaf and a rotation guide according to various embodiments of the disclosure.
FIG. 7B is a side view showing a hinge base according to various embodiments of the disclosure.
FIG. 8A is a side view showing a detent operation in a closed state of a hinge of the disclosure.
FIG. 8B is a side view showing a free stop operation of a hinge of the disclosure.
FIG. 8C is a side view showing a detent operation in an open state of a hinge of the disclosure.
FIG. 9A is a schematic view showing an operation of a force transmission member of a hinge according to some embodiments of the disclosure.
FIG. 9B is a schematic view showing an operation of a force transmission member of a hinge according to another embodiment of the disclosure.
FIG. 9C is a schematic view showing an operation of a force transmission member of a hinge according to another embodiment of the disclosure.
FIG. 10A is a perspective view showing a hinge according to another embodiment of the disclosure.
FIG. 10B is an exploded perspective view of a hinge according to another embodiment of the disclosure.

### [Mode for the Invention]

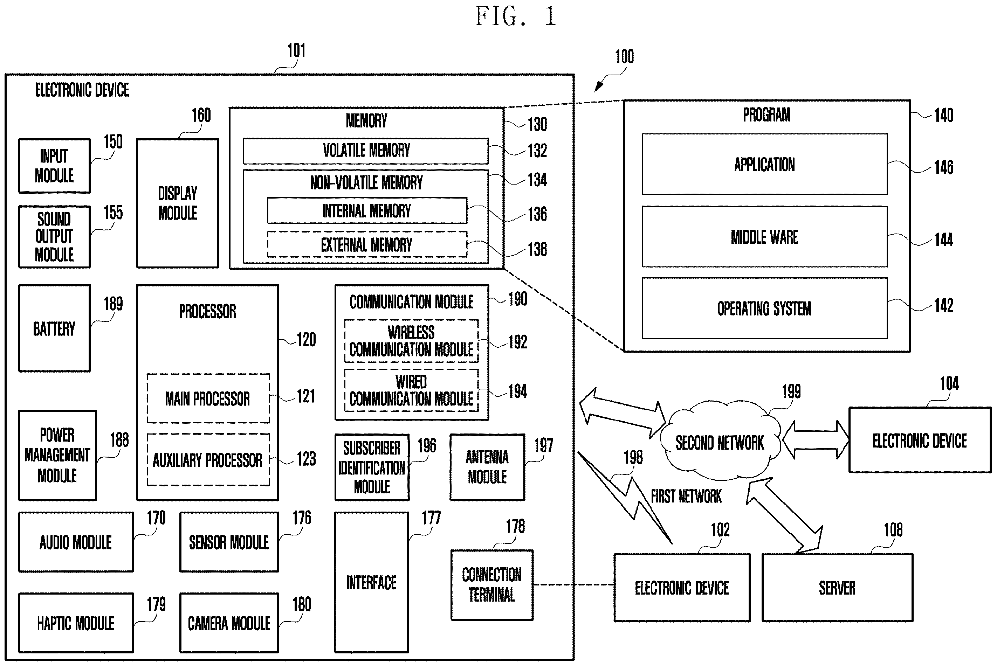

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, a portable electronic device (e.g., the electronic device 101 in FIG. 1) may have a foldable housing divided into two housings around a folding axis. A first portion of a display (e.g., a flexible display) may be disposed in a first housing, and a second portion of the display may be disposed in a second housing. The foldable housing may be implemented in an in-folding type in which the first portion and the second portion face each other in case that the portable electronic device is folded. In addition, the foldable housing may be also implemented in an out-folding type in which the first portion and the second portion are oriented in directions opposite to each other in case that the portable electronic device is folded. A surface, on which the first portion and the second portion of the display are arranged, may be defined as the front surface of the portable electronic device, a surface opposite thereto may be defined as the rear surface of the portable electronic device, and a surface surrounding a space between the front surface and the rear surface may be defined as a side surface of the portable electronic device.

According to an embodiment mentioned in the document, although an in-folding type, in which the first portion of the display in the first housing and the second portion of the display in the second housing are arranged to face each other in case that the display of the portable electronic device is folded, is illustrated and described as an example, an embodiment mentioned in the document may also be identically applied to an out-folding type in which the first portion of the display in the first housing 210 and the second portion of the display in the second housing are arranged to be oriented in directions opposite to each other in case that the display is folded according to an embodiment. In addition, an embodiment may also be applied to a multi-foldable electronic device in which an in-folding type and an in-folding type are combined, an in-folding type and an out-folding type are combined, and an out-folding type and an out-folding type are combined.

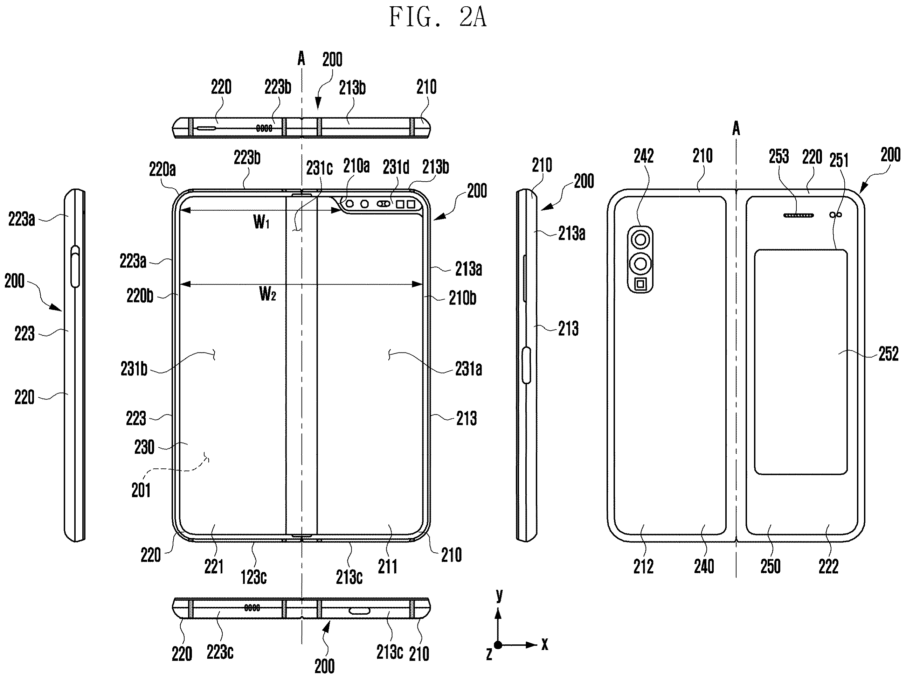

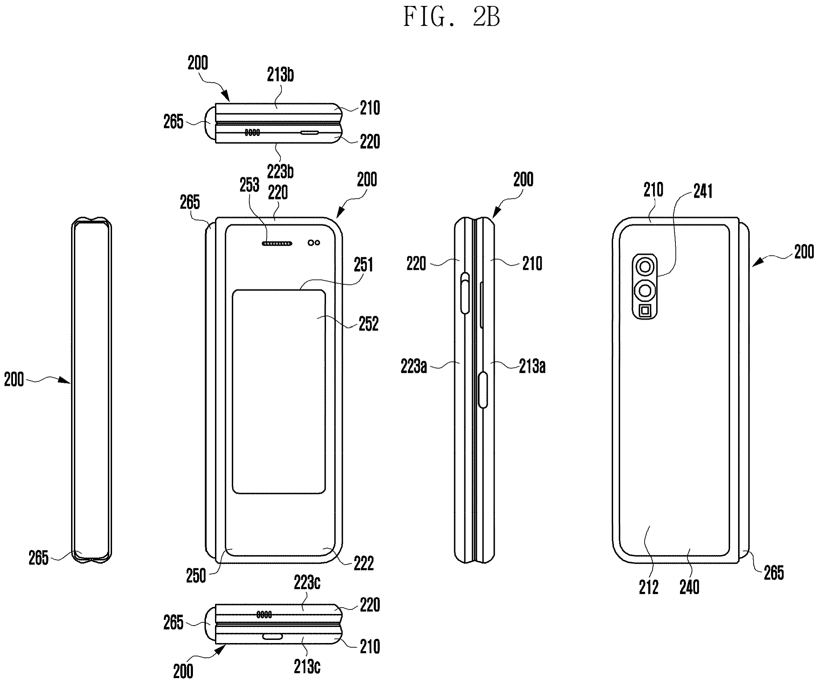

FIG. 2A is a view showing an unfolded state of an electronic device 200 according to various embodiments of the disclosure. FIG. 2B is a view showing a folded state of the electronic device 200 in FIG. 2A according to various embodiments of the disclosure.

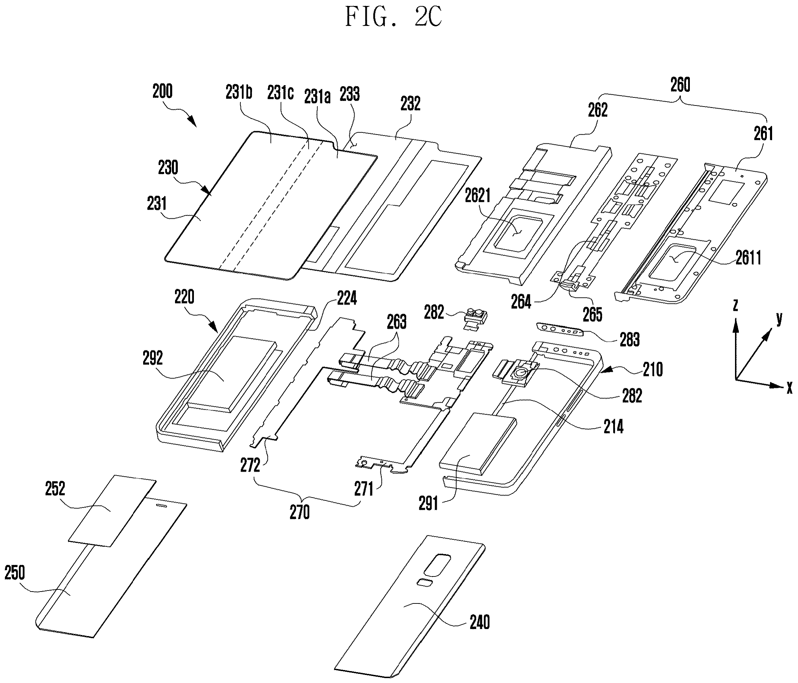

Referring to FIG. 2A, an electronic device 200 may include a pair of housings 210 and 220 (e.g., a foldable housing structure) rotatably coupled through a hinge (e.g., the hinge 264 in FIG. 2C) to be folded to each other, a hinge cover (e.g., the hinge cover 265 in FIG. 2B) for covering the foldable portion of the pair of housings 210 and 220, and a display 230 (e.g., a flexible display, a foldable display or, a first display) disposed in a space formed by the pair of housings 210 and 220.

In the document, a surface, on which the display 230 is disposed, may be defined as the front surface of the electronic device 200, and a surface opposite to the front surface may be defined as the rear surface of the electronic device 200.

In the document, a surface, which surrounds a space between the front surface and the rear surface, may be defined as the side surface of the electronic device 200.

In the document, the direction, in which the front surface is oriented, may be defined as a first direction, and the direction, in which the rear surface is oriented, may be defined as a second direction.

In describing a stacking order (e.g., the stacking order of a display) in the document, the expression "a layer B is formed above a layer A" may mean that the layer B is formed in the first direction from the layer A. Alternatively, in describing a stacking order (e.g., the stacking order of a display) in the document, the expression "a layer B is formed below layer A" may mean that the layer B is formed in the second direction from the layer A.

In an embodiment, the one pair of housings 210 and 220 may include a first housing 210 including a sensor area 231d, a second housing 220, a first rear cover 240, and a second rear cover 250. The one pair of housings 210 and 220 of the electronic device 200 are not limited to the shape and the combination as illustrated in FIG. 2A and FIG. 2B, and may be implemented by other shapes or a combination and/or coupling of components. For example, in another embodiment, the first housing 210 and the first rear cover 240 may be integrally formed, and the second housing 220 and the second rear cover 250 may be integrally formed.

According to an embodiment, the first housing 210 and the second housing 220 may be arranged at both sides around a folding axis (the axis A), and may have a substantially symmetrical shape with respect to the folding axis (the axis A). According to an embodiment, the first housing 210 and the second housing 220 may have different angles formed by each other or different distances from each other, depending on whether a state of the electronic device 200 is in an unfolded state (e.g. a flat state or a completely unfolded state), a folded state(e.g. a completely folded state), or an intermediate state(e.g. between the completely folded state and the completely unfolded state). According to an embodiment, differently from the second housing 220, the first housing 210 may additionally include the sensor area 231d in which various sensors are arranged, but, the first housing and the second housing may have a mutually symmetrical shape in other areas. As another embodiment, the sensor area 231d may be additionally provided in at least partial area of the second housing 220 or may be replaced.

In an embodiment, the electronic device 200 may be configured such that the first housing 210 rotates with respect to the second housing 220 by means of a hinge (e.g., the hinge 264 in FIG. 2C) within a range of 0 degrees - 360 degrees, and thus may operate in an in-folding manner and/or in an out-folding manner. According to various embodiments, a hinge 264 may be formed in a vertical direction or formed in a horizontal direction when the electronic device 200 is seen from above. According to various embodiments, multiple hinges 264 may be provided. For example, all the multiple hinges may be arranged in the same direction. As another example, some hinges among the multiple hinges may be arranged in different directions to be folded.

In an embodiment, in an unfolded state of the electronic device 200, the first housing 210 may include a first surface 211 connected to a hinge (e.g., the hinge 264 in FIG. 2C) and disposed to face the front surface of the electronic device 200, a second surface 212 oriented in a direction opposite to the first surface 211, and a first lateral member 213 for surrounding at least a part of a space between the first surface 211 and the second surface 212. In an embodiment, the first lateral member 213 may include a first side surface 213a disposed parallel to the folding axis (the axis A), a second side surface 213b extending from one end of the first side surface 213a in a direction perpendicular to the folding axis, and a third side surface 213c extending from the other end of the first side surface 213a in a direction perpendicular to the folding axis (the axis A).

In an embodiment, in an unfolded state of the electronic device 200, the second housing 220 may include a third surface 221 connected to a hinge (e.g., the hinge 264 in FIG. 2C) and disposed to face the front surface of the electronic device 200, a fourth surface 222 oriented in a direction opposite to the third surface 221, and a second side member 223 for surrounding at least a part of a space between the third surface 221 and the fourth surface 222. In an embodiment, the second lateral member 223 may include a fourth side surface 223a disposed parallel to the folding axis (the axis A), a fifth side surface 223b extending from one end of the fourth side surface 223a in a direction perpendicular to the folding axis (the axis A), and a sixth side surface 223c extending from the other end of the fourth side surface 223a in a direction perpendicular to the folding axis (the axis A). In an embodiment, the third surface 221 may be disposed to face the first surface 211 in a folded state.

In an embodiment, the electronic device 200 may include a recess 201 formed by a structural shape coupling between the first housing 210 and the second housing 220 so as to accommodate the display 230. The recess 201 may have substantially the same size as the display 230. In an embodiment, due to the sensor area 231d, the recess 201 may have two widths different from each other in a direction perpendicular to the folding axis (the axis A). For example, the recess 201 may have a first width W1 between a first portion 220a of the second housing 220, which is parallel to the folding axis (the axis A), and a first portion 210a of the first housing 210, which is formed at the edge of the sensor area 231d, and may have a second width W2 formed by a second portion 220b of the second housing 220 and a second portion 210b of the first housing 210, which is other than the sensor area 231d and is parallel to the folding axis (the axis A). In this case, the second width W2 may be formed longer than the first width W1. For example, the recess 201 may be formed to have the first width W1 which is formed from the first portion 210a of the first housing 210 to the first portion 220a of the second housing 220, the first portion 210a and the first portion 220a having a mutually asymmetric shape, and to have the second W2 which is formed from the second portion 210b of the first housing 210 to the second portion 220b of the second housing 220, the second portion 210b and the second portion 220b having a mutually symmetrical shape. In an embodiment, the first portion 210a and the second portion 210b of the first housing 210 may be formed to have distances different from the folding axis (the axis A). The width of the recess 201 is not limited to the illustrated embodiment. In an embodiment, the recess 201 may have two or more widths different from each other by the shape of the sensor area 231d or the portions of the first housing 210 and the second housing 220, which have an asymmetric shape.

In an embodiment, at least a part of the first housing 210 and the second housing 220 may be formed of a metal material or a non-metal material having rigidity of a magnitude selected to support the display 230.

In an embodiment, the sensor area 231d may be formed to have a predetermined area adjacent to a side corner of the first housing 210. However, the arrangement, shape, or size of the sensor area 231d is not be limited to the illustrated embodiment. For example, in another embodiment, the sensor area 231d may be provided in other corners of the first housing 210 or any area between the top corner and the bottom corner thereof. As another embodiment, the sensor area 231d may be disposed in at least a partial area of the second housing 220. As another embodiment, the sensor area 231d may be disposed to extend from the first housing 210 and the second housing 220. In an embodiment, the electronic device 200 may include components for performing various functions, which are arranged to be exposed on the front surface of the electronic device 200 through the sensor area 231d or through one or more openings provided through the sensor area 231d. In an embodiment, for example, the components may include at least one of a front camera device, a receiver, a proximity sensor, an illuminance sensor, an iris recognition sensor, an ultrasonic sensor, or an indicator.

In an embodiment, the first rear cover 240 may be disposed on the second surface 212 of the first housing 210 and may have a substantially rectangular edge (periphery). In an embodiment, at least a part of the edge may be surrounded by the first housing 210. Similarly thereto, the second rear cover 250 may be disposed on a fourth surface 222 of the second housing 220, and at least a part of the edge thereof may be surrounded by the second housing 220.

In the illustrated embodiment, the first rear cover 240 and the second rear cover 250 may have a substantially symmetrical shape with reference to the folding axis (the axis A). As another embodiment, the first rear cover 240 and the second rear cover 250 may include various shapes different from each other. As another embodiment, the first rear cover 240 may be integrally formed with the first housing 210, and the second rear cover 250 may be integrally formed with the second housing 220.

In an embodiment, the first rear cover 240, the second rear cover 250, the first housing 210, and the second housing 220 may provide a space, in which various components (e.g., a printed circuit board, an antenna module, a sensor module, or a battery) of the electronic device 200 may be arranged, through a structure formed by being coupled to one another. In an embodiment, one or more components may be arranged or may be visually exposed on the rear surface of the electronic device 200. For example, one or more components or sensors may be visually exposed through a first rear area 241 of the first rear cover 240. In an embodiment, the sensor may include a proximity sensor, a rear camera device, and/or a flash. In another embodiment, at least a part of a sub-display 252 (e.g., a second display) may be visually exposed through a second rear area 251 of the second rear cover 250. In another embodiment, the electronic device 200 may include a speaker module 253 disposed through at least a partial area of the second rear cover 250.

The display 230 may be disposed in a space formed by the one pair of housings 210 and 220. For example, the display 230 may be seated in the recess 201 formed by the one pair of housings 210 and 220, and may be disposed to substantially occupy the majority of the front surface of the electronic device 200. Accordingly, the front surface of the electronic device 200 may include the display 230, and a partial area (e.g., an edge area) of the first housing 210 and a partial area (e.g., an edge area) of the second housing 220, which are adjacent to the display 230. In an embodiment, the rear surface of the electronic device 200 may include the first rear cover 240, a partial area (e.g., an edge area) of the first housing 210, which is adjacent to the first rear cover 240, the second rear cover 250, and a partial area (e.g., an edge area) of the second housing 220, which is adjacent to the second rear cover 250.

In an embodiment, the display 230 may mean a display of which at least a partial area may be deformed into a flat surface or a curved-surface. In an embodiment, the display 230 may include a folding area 231c, a first area 231a disposed at one side (e.g., the right area of the folding area 231c) with reference to the folding area 231c, and a second area 231b disposed at the other side (e.g., the left area of the folding area 231c) thereof. For example, the first area 231a may be disposed on the first surface 211 of the first housing 210, and the second area 231b may be disposed on the third surface 221 of the second housing 220. In an embodiment, the division of an area of the display 230 may be exemplary, and an area of the display 230 may be divided into multiple (e.g., four or more, or two) areas according to a structure or a function thereof. For example, in the embodiment as illustrated in FIG. 2A, an area of the display 230 may be divided by the folding area 231c extending parallel to the y-axis or the folding axis (the axis A), but in another embodiment, an area of the display 230 may be divided with reference to another folding area (e.g., a folding area parallel to the x-axis) or another folding axis (e.g., a folding axis parallel to the x-axis). The division of an area of the display described above may be merely a physical division by the one pair of housings 210 and 220 and a hinge (e.g., the hinge 264 in FIG. 2C), and substantially, the display 230 may be displayed as one entire screen through the one pair of housings 210 and 220 and the hinge (e.g., the hinge 264 in FIG. 2C). In an embodiment, the first area 231a and the second area 231b may have an overall symmetrical shape with reference to the folding area 231c. However, differently from the second area 231b, the first area 231a may include a notch area (e.g., the notch area 233 in FIG. 2C) which is cut according to the presence of the sensor area 231d, and in an area other than the sensor area 231d, may have a symmetrical shape with the second area 231b. For example, the first area 231a and the second area 231b may include portions having a shape symmetric to each other and portions having a shape asymmetric to each other.

Referring to FIG. 2B, a hinge cover 265 may be disposed between the first housing 210 and the second housing 220 and be configured to cover an internal component (e.g., the hinge 264 in FIG. 2C). In an embodiment, the hinge cover 265 may be covered by a part of the first housing 210 and the second housing 220 or may be exposed to the outside according to an operation state (an unfolded state (a flat state) or a folded state) of the electronic device 200.

As an example, as illustrated in FIG. 2A, in case that the electronic device 200 is in an unfolded state, the hinge cover 265 may be covered by the first housing 210 and the second housing 220 and thus may not be exposed. As an example, as illustrated in FIG. 2B, in case that the electronic device 200 is in a folded state (e.g., a completely folded state), the hinge cover 265 may be exposed to the outside, between the first housing 210 and the second housing 220. As an example, in case that the electronic device is in an intermediate state in which the first housing 210 and the second housing 220 are folded with a certain angle, the hinge cover 265 may be at least partially exposed to the outside the electronic device 200, between the first housing 210 and the second housing 220. In this case, the exposed area may be smaller than that of the completely folded state. In an embodiment, the hinge cover 265 may include a curved-surface.

Hereinafter, the operation of the first housing 210 and the second housing 220 and each area of the display 230 according to an operation state (e.g., an unfolded state (a flat state) and a folded state) of the electronic device 200 will be described.

In an embodiment, in case that the electronic device 200 is in an unfolded state (a flat state) (e.g., the state in FIG. 2A), the first housing 210 and the second housing 220 may form an angle of 180 degrees, and thus the first area 231a and the second area 231b of the display may be arranged to be oriented in the same direction. In addition, the folding area 231c may form the same flat surface as the first area 231a and the second area 231b. As another embodiment, in case that the electronic device 200 is in a folded state (a flat state), the first housing 210 and the second housing 220 may be reversely folded such that the second surface 212 and the fourth surface 222 face each other, and thus the first area 231a and the second area 231b of the display may be arranged to be oriented in directions opposite to each other.

In an embodiment, in case that the electronic device 200 is in a folded state (e.g., the state in FIG. 2B), the first housing 210 and the second housing 220 may be arranged to face each other. The first area 231a and the second area 231b of the display 230 may form a narrow angle (e.g., an angle between 0 degrees and 10 degrees), and may also face each other. At least a part of the folding area 231c may be formed as a curved-surface having a predetermined curvature.

In an embodiment, in case that the electronic device 200 is in an intermediate state, the first housing 210 and the second housing 220 may be arranged at a certain angle to each other. The first area 231a and the second area 231b of the display 230 may form an angle larger than that a folded state and smaller than that of an unfolded state. At least a part of the folding area 231c may be formed as a curved-surface having a predetermined curvature, and at this time, the curvature may be smaller than that of a folded state.

FIG. 2C is an exploded perspective view of the electronic device 200 according to various embodiments of the disclosure.

Referring to FIG. 2C, in an embodiment, the electronic device 200 may include the display 230, a support member assembly 260, at least one printed circuit board 270, the first housing 210, the second housing 220, the first rear cover 240, and the second rear cover 250. In the document, the display (display unit) 230 (e.g., a first display) may be referred to as a display module or a display assembly.

The display 230 may include a display panel 231 (e.g., a flexible display panel) and one or more plates 232 or layers on which the display panel 231 is seated. In an embodiment, the one or more plates 232 may include a conductive plate (e.g., a Cu sheet or a SUS sheet) disposed between the display panel 231 and the support member assembly 260. According to an embodiment, the conductive plate may be formed to have substantially the same area as the display, and the area of the conductive plate, which faces the folding area of the display, may be formed to be bendable. The plate 232 may include at least one sub-material layer (e.g., a graphite member) disposed on the rear surface of the display panel 231. In an embodiment, the plate 232 may be formed in a shape corresponding to the display panel 231. For example, a partial area of the first plate 232 may be formed in a shape corresponding to the notch area 233 of the display panel 231.

The support member assembly 260 may include a first support member 261 (e.g., a first support plate), a second support member 262 (e.g., a second support plate), the hinge 264 disposed between the first support member 261 and the second support member 262, the hinge cover 265 for covering the hinge 264 when seen from the outside thereof, and at least one wire member 263 (e.g., a flexible printed circuit board (FPCB)) crossing the first support member 261 and the second support member 262.

In an embodiment, the support member assembly 260 may be disposed between the plate 232 and the at least one printed circuit board 270. As an example, the first support member 261 may be disposed between the first area 231a of the display 230 and a first printed circuit board 271. The second support member 262 may be disposed between the second area 231b of the display 230 and a second printed circuit board 272.

In an embodiment, at least a part of the wire member 263 and the hinge 264 may be arranged inside the support member assembly 260. The wire member 263 may be disposed in a direction (e.g., the x-axis direction) crossing the first support member 261 and the second support member 262. The wire member 263 may be disposed in a direction (e.g., the x-axis direction) perpendicular to the folding axis (e.g., the y-axis or the folding axis A in FIG. 2A) of the folding area 231c.

In an embodiment, as mentioned above, the at least one printed circuit board 270 may include the first printed circuit board 271 disposed at the side of the first support member 261 and the second printed circuit board 272 disposed at the side of the second support member 262. The first printed circuit board 271 and the second printed circuit board 272 may be arranged in a space formed by the support member assembly 260, the first housing 210, the second housing 220, the first rear cover 240, and the second rear cover 250. Components for implementing various functions of the electronic device 200 may be mounted on the first printed circuit board 271 and the second printed circuit board 272.

In an embodiment, the first printed circuit board 271 disposed in a space formed through the first support member 261, a first battery 291 disposed at a position facing a first swelling hole 2611 of the first support member 261, at least one sensor module 281, or at least one camera module 282 may be included in a first space of the first housing 210. The first housing 210 may include a window glass 283 disposed to protect at least one sensor module 281 and at least one camera module 282 at a position corresponding to the notch area 233 of the display 230. In an embodiment, the second printed circuit board 272 disposed in a second space formed through the second support member 262, and a second battery 292 disposed at a position facing a second swelling hole 2621 of the second support member 262 may be included in a second space of the second housing 220. According to an embodiment, the first housing 210 and the first support member 261 may be integrally formed. According to an embodiment, the second housing 220 and the second support member 262 may also be integrally formed. According to an embodiment, the sub-display 252 may be disposed in the second space of the second housing 220. According to an embodiment, the sub display 252 (e.g., a second display) may be disposed to be visible from the outside through at least a partial area of the second rear cover 250.

In an embodiment, the first housing 210 may include a first rotation support surface 214, and the second housing 220 may include a second rotation support surface 224 corresponding to the first rotation support surface 214. Each of the first rotation support surface 214 and the second rotation support surface 224 may include a curved-surface corresponding to the curved-surface included in the hinge cover 265.

In an embodiment, in case that the electronic device 200 is in an unfolded state (e.g., the state in FIG. 2A), the first rotation support surface 214 and the second rotation support surface 224 may cover the hinge cover 265 to prevent the hinge cover 265 from being exposed to the rear surface of the electronic device 200 or to allow the hinge cover to be minimally exposed. In an embodiment, in case that the electronic device 200 is in a folded state (e.g., the state in FIG. 2B), the first rotation support surface 214 and the second rotation support surface 224 may rotate along the curved-surface included in the hinge cover 265 to maximally expose the hinge cover 265 to the rear surface of the electronic device 200.

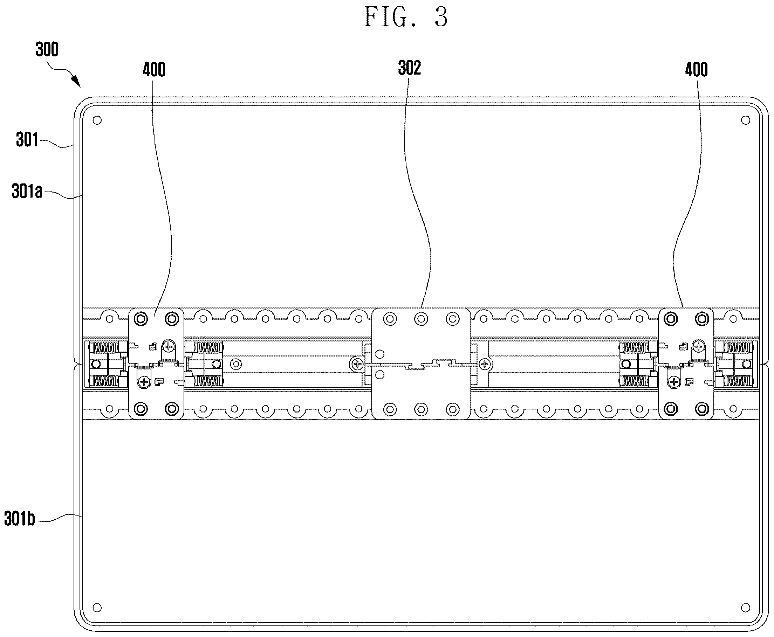

FIG. 3 is a plan view showing a foldable enclosure 301 and a hinge 400 of a foldable electronic device 300 according to various embodiments of the disclosure.

Referring to FIG. 3, a foldable electronic device 300 includes multiple sub-enclosures 301a and 301b (for example, the housings 210 and 220 in FIG. 2A), and includes a foldable enclosure 301 which is foldable and unfoldable, and at least one hinge 400 for rotatably connecting the multiple sub-enclosures 301a and 301b around at least one axis. The hinge 400 is coupled to sub-enclosures 301a and 301b (for example, the hinge 400 may be coupled to an end of each of the sub-enclosures 301a and 301b), and is a portion which allows each of the sub-enclosures 301a and 301b to rotate along a predetermined rotation trajectory thereof so that the foldable enclosure 301 can be folded or unfolded. Detailed configurations of the hinge 400 will be described later with reference to the following drawings.

In some embodiments, the foldable electronic device 300 may include an auxiliary hinge 302. The auxiliary hinge 302 may synchronize rotation operations of the multiple sub-enclosures 301a and 301b so that folding operations of the multiple sub-enclosures 301a and 301b are performed simultaneously. Although not illustrated, the auxiliary hinge 302 may include multiple gears engaged with each other in order to synchronize the rotation operations thereof.

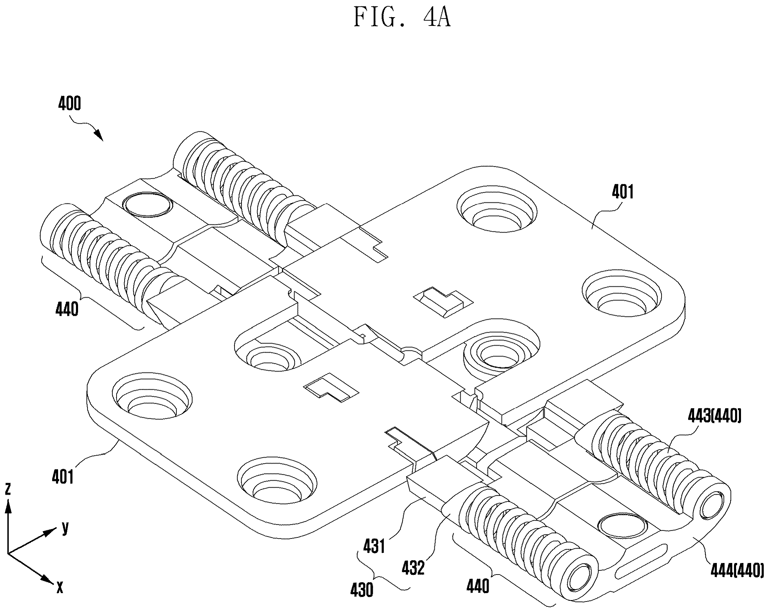

FIG. 4A is a perspective view showing an unfolded state of a hinge 400 according to various embodiments of the disclosure.

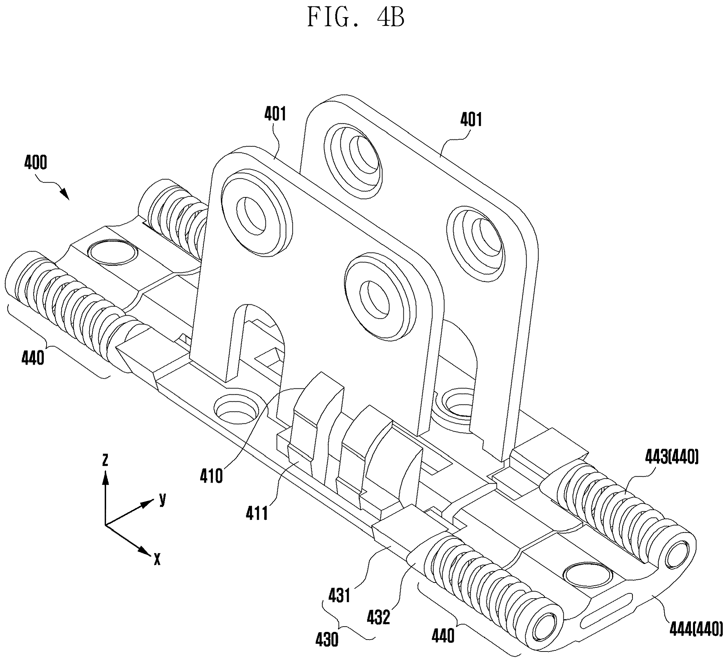

FIG. 4B is a perspective view showing a folded state of a hinge 400 according to various embodiments of the disclosure.

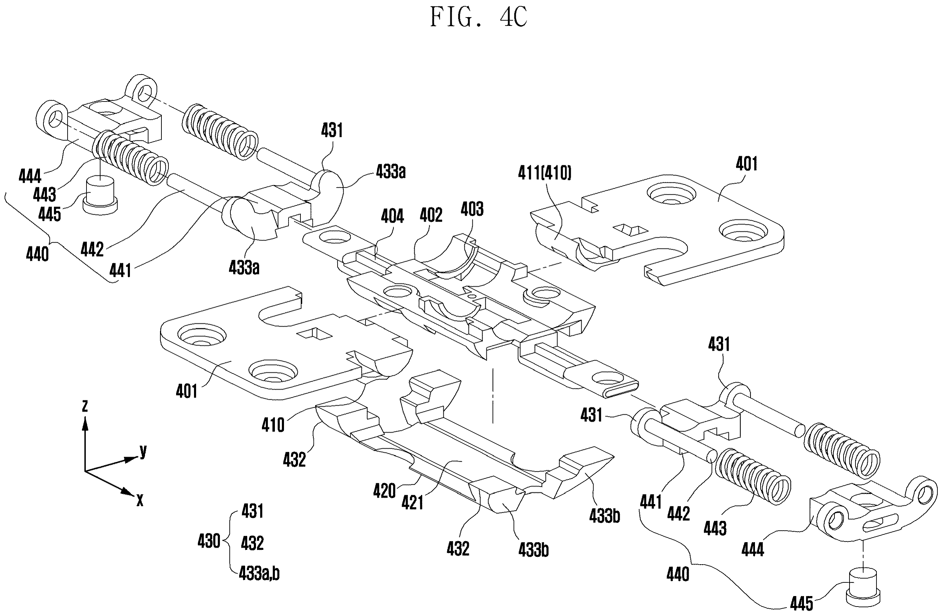

FIG. 4C is an exploded perspective view of a hinge 400 according to various embodiments of the disclosure.

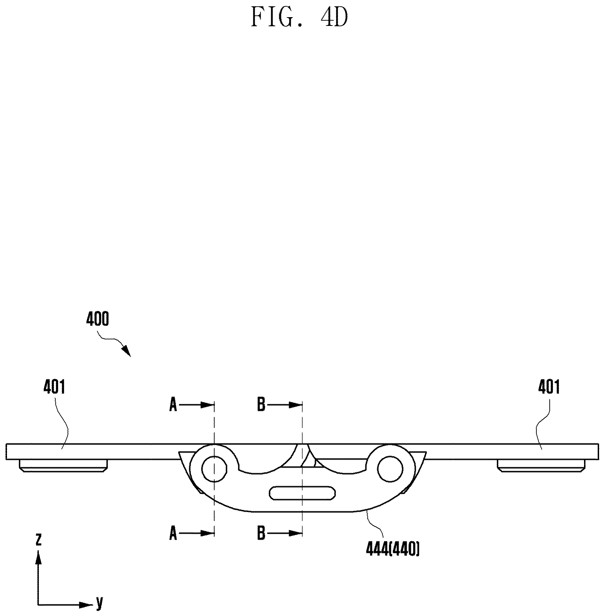

FIG. 4D is a side view of a hinge 400 according to various embodiments of the disclosure.

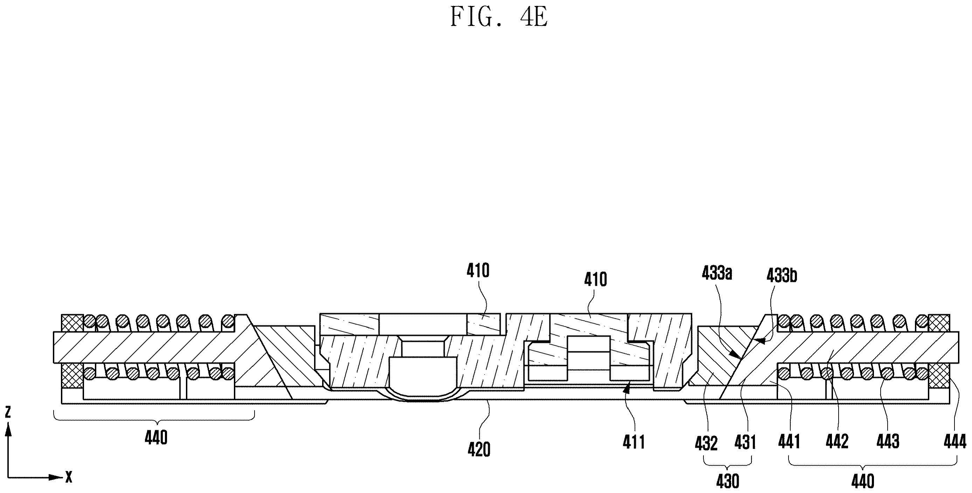

FIG. 4E is a cross-sectional view of a hinge 400 according to various embodiments of the disclosure.

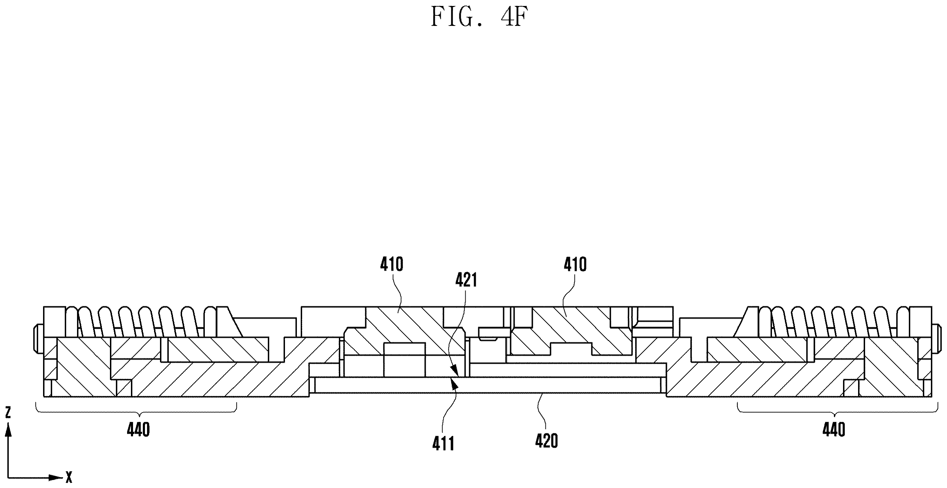

FIG. 4F is a cross-sectional view of a hinge 400 seen in another direction according to various embodiments of the disclosure.

The cross-sections in FIG. 4E and FIG. 4F are cross-sections taken along direction A-A' and direction B-B' in FIG. 4D, respectively.

Referring to FIG. 4A to FIG. 4F together, the hinge 400 includes multiple hinge leaves 401, multiple rotation guides 410, a force transmission member 420, a force diverting part 430, and a hinge actuator 440 and may include a hinge base 402.

The hinge base 402 may be an element to which elements of the hinge 400 to be described later are coupled and which supports a rotation and/or a sliding motion of each of the elements. In some embodiments, the hinge base 402 may include a rotational sliding rail 404 for supporting a rotational sliding motion of the rotation guides 410 to be described later. In some embodiments, the hinge base 402 may include a sliding rail 404 for supporting a sliding motion of the hinge actuator 440 to be described later.

The multiple hinge leaves 401 are coupled to the multiple sub-enclosures 301a and 301b, respectively, and are a member which is coupled to the rotation guides 410 to be described later and rotates to rotate the multiple sub-enclosures 301a and 301b. The hinge leaves 401 may be coupled to the sub-enclosures 301a and 301b by screws, rivets, or various fastening means similar thereto. Although not illustrated, in some embodiments, the hinge leaves 401 may be coupled to be slidable with respect the sub-enclosures 301a and 301b in order to implement the characteristic of a "blooming hinge 400" in which the distance between the sub-enclosures 301a and 301b from the rotation axis of the hinge 400 is changed according to a rotation angle of the hinge 400.

The multiple rotation guides 410 may be coupled to one end of the multiple hinge leaves 401, respectively, or are formed on a portion of the hinge leaves 401, respectively. Each of the rotation guides 410 includes a rotation surface 411 having a curved-surface corresponding to the rotation trajectory of the hinge leaves 401. For example, the trajectory, by which the hinge leaves 401 are rotated, may follow various curves such as, an arc, an ellipse, or a hyperbola. The rotation guides 410 may be rotatably and/or slidably coupled to rails of the rotation guides 403 of the hinge base 402 described above.

In some embodiments, the rotation surface 411 may include a cam surface 412 for generating detent torque which is torque in a direction opposite to the rotation direction of the hinge 400 at at least one rotation angle of the hinge 400. Detailed configurations of the rotation surface 411 will be described later.

The force transmission member 420 is a member including a pressing surface 421 which comes into contact with and presses the rotation surfaces 411 of the rotation guides 410. Referring to FIG. 4F, the force transmission member 420 may be positioned below (the - z-axis direction) of the hinge base 402, and may press the rotation surfaces 411 of the rotation guides 410 upward (the z-axis direction) from therebelow by using the pressing surface 421. The pressing surface 421 may be pressed against the rotation surfaces 411 and thus cause friction, and therefore it may be possible to generate a free stop effect in which the hinge 400 is fixed at an arbitrary angle. In some embodiments, the pressing surface 421 may press the cam surfaces 412 on the rotation surfaces 411 to generate detent torque.

The hinge actuator 440 may be a part for generating a force for a free stop and/or a detent effect of the hinge 400. In some embodiments, the hinge actuator 440 may include an elastic member, for example, a spring 443 in order to generate a force. The hinge actuator 440 is disposed to generate a force in a direction substantially parallel to the pressing surface 421, so as to reduce the entire thickness of the hinge 400 and save the inner space of the foldable electronic device 300. Although the configuration, in which the hinge actuator 440 applies a force in a direction substantially parallel to the rotation axis (the y-axis) of the hinge 400, is illustrated in FIG. 4A to FIG. 4C, the disclosure is not limited thereto.

The force diverting part 430 changes the direction of a force generated by the hinge actuator 440 to a direction substantially perpendicular to the pressing surface 421, and then applies the force to the force transmission member 420. Referring to FIG. 4E, in some embodiments, the force diverting part 430 may include at least one inclined surface 433 inclined with respect to a direction in which the pressing surface 421 presses the rotation surface 411. In some embodiments, the force diverting part 430 may include a first slider 431 coupled to the hinge actuator 440 and a second slider 432 coupled to the force transmission member 420 and in slidable contact against the first slider 431. The inclined surface 433 may be formed on at least one of the first slider 431 and the second slider 432. For example, as illustrated in FIG. 4E, the first slider 431 may include a first inclined surface 433a, and the second slider 432 may include a second inclined surface 433b. By an inclined sliding motion between the first slider 431 and the second slider 432, which is generated on the inclined surface 433, the direction of a force generated by the hinge actuator 440 may be changed to the pressing direction of the pressing surface 421. Various configurations and operations of the force diverting part 430 will be described later.

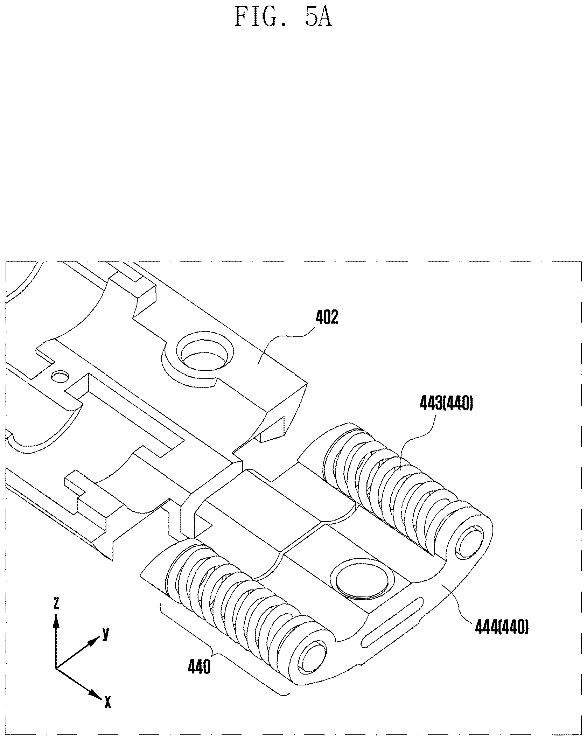

FIG. 5A is a perspective view showing a hinge actuator 440 of a hinge 400 according to various embodiments of the disclosure.

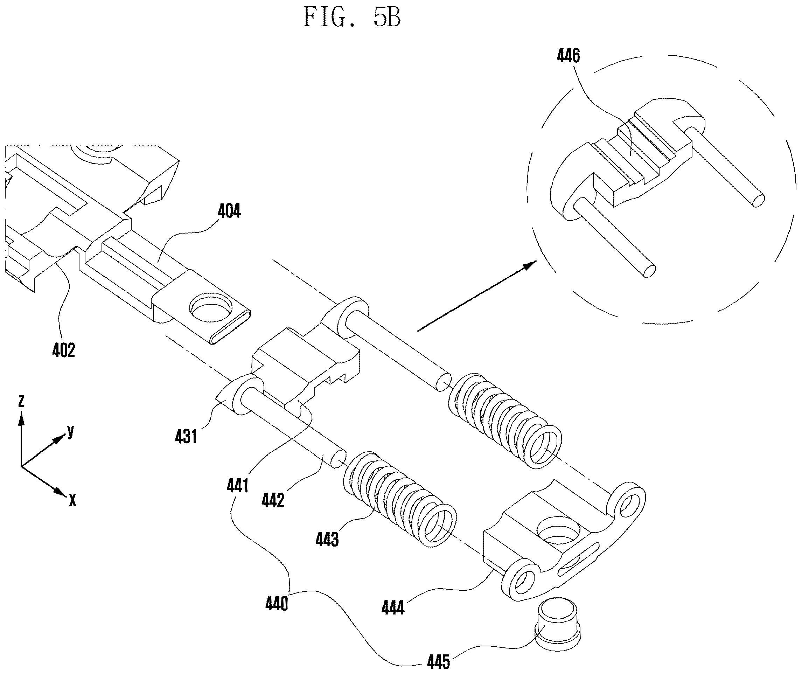

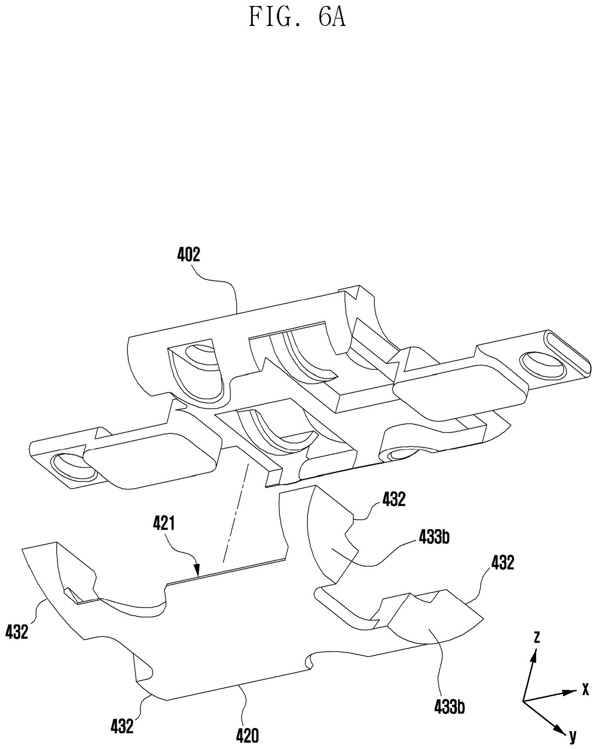

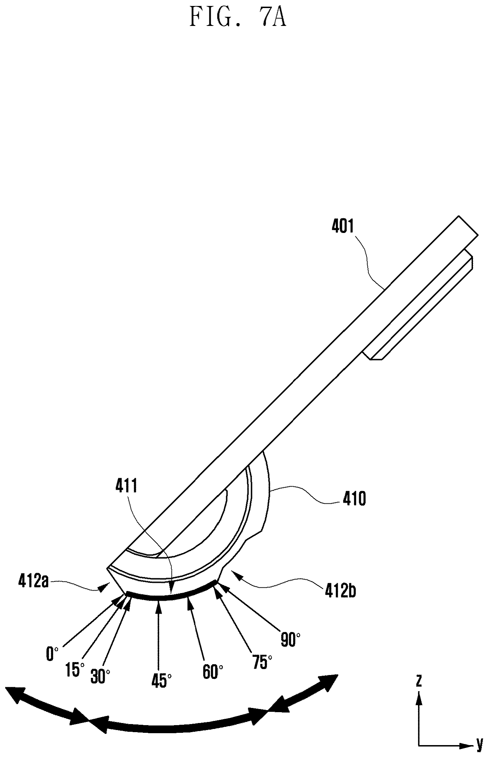

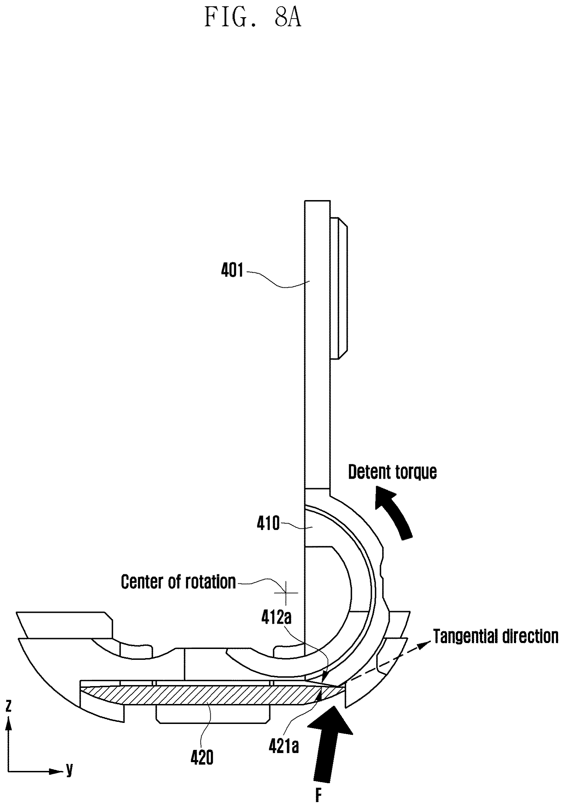

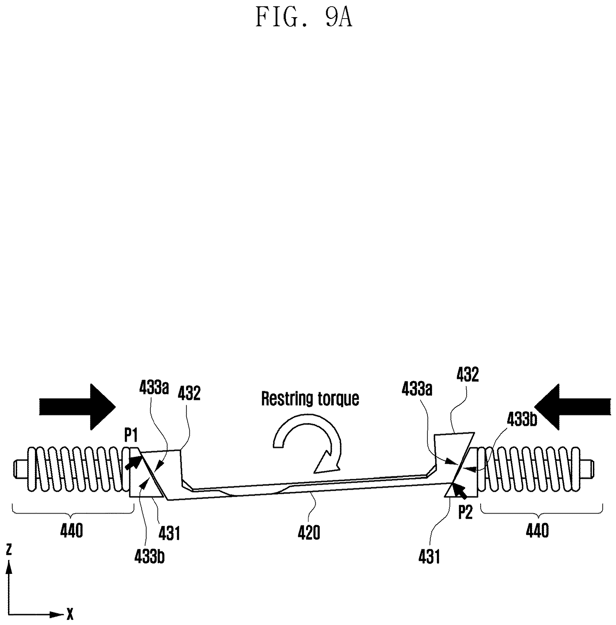

FIG. 5B is an exploded perspective view showing a hinge actuator 440 of a hinge 400 according to various embodiments of the disclosure. It will be appreciated that the aspects of the hinge actuator 440 described with reference to FIG. 5A to FIG. 5B below may be combined with one or more aspects of the disclosure, including, but not limited to, aspects of the hinge 400 described with reference to FIG. 4A to FIG. 4F, aspects of the hinge base 402 and force transmission member 420 described with reference to FIG. 6A to FIG. 6B, aspects of the hinge leaf 401 and rotation guide 410 described with reference to FIG. 7A to FIG. 7B, aspects of the detent operation described with reference to FIG. 8A to FIG. 8C, and aspects of the force transmission member 420 described with reference to FIG. 9A to FIG. 9C.

Referring to FIG. 5A and FIG. 5B, the hinge actuator 440 may include a pusher 441, a spring 443, and a spring holder 444. The pusher 441 may be a member which is driven by the spring 443 and thus applies a force to the force transmission member 420. In some embodiments, the first slider 431 may be formed at one end of the pusher 441. In some embodiments, the hinge base 402 may include a sliding rail 404 for guiding a sliding motion of the pusher 441, and the pusher 441 may include a sliding guide 446 coupled to be slidable with respect to the sliding rail 404.

The spring 443 may be a member which applies a force to the pusher 441 by using an elastic force. Although a coil spring is illustrated, the spring 443 is not limited to a coil spring, and for example, may include a volute spring or a conical spring, or may include various elastic members other than or in addition to a spring. Although FIG. 5A and FIG. 5B illustrate an embodiment in which the spring 443 is oriented to apply a force in a direction substantially parallel to the rotation axis (the y-axis), the disclosure is not limited thereto. In some embodiments, the pusher 441 may include a spring guide 442, and thus straightness of the spring 443 may be maintained by the spring guide 442.

The spring holder 444 may be a member which limits the movement of the end of the spring 443 and thus supports the spring 443 such that the spring 443 applies an elastic force to the pusher 441. In some embodiments, the spring holder 444 may be fastened to the hinge base 402 by a fastening means such as a pin 445.

FIG. 6A is a perspective view showing a hinge base 402 and a force transmission member 420 according to various embodiments of the disclosure.

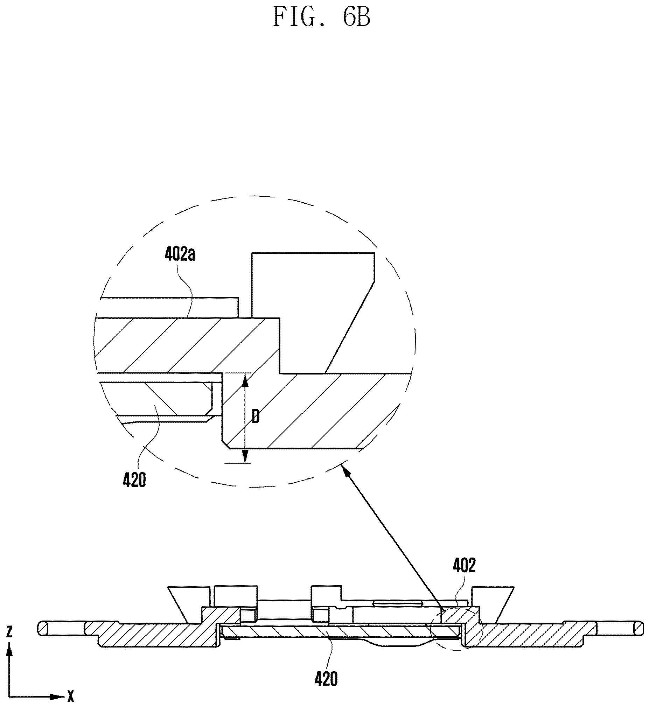

FIG. 6B is a cross-sectional view showing a hinge base 402 and a force transmission member 420 according to various embodiments of the disclosure. It will be appreciated that the aspects of the hinge actuator hinge base 402 and force transmission member 420 described with reference to FIG. 6A to FIG. 6B below may be combined with one or more aspects of the disclosure, including, but not limited to, aspects of the hinge 400 described with reference to FIG. 4A to FIG. 4F, aspects of the hinge actuator 440 described with reference to FIG. 5A to FIG. 5B, aspects of the hinge leaf 401 and rotation guide 410 described with reference to FIG. 7A to FIG. 7B, aspects of the detent operation described with reference to FIG. 8A to FIG. 8C, and aspects of the force transmission member 420 described with reference to FIG. 9A to FIG. 9C.

The cross-section of FIG. 6B corresponds to the cross-section taken along direction A-A' in FIG. 4D.

Referring to FIG. 6A, the force transmission member 420 may be coupled to be movable with respect to the hinge base 402 at the lower part (the -z direction) of the hinge base 402. In some embodiments, the force transmission member 420 may have the end to which the second slider 432 is fixed and coupled, and thus may receive a force of the hinge actuator 440, of which the direction is changed to the upward direction (the z direction) through the inclined surface 433 of the second slider 432. The second sliders 432 may be symmetrically arranged at opposite ends of the force transmission member 420 so that the forces transmitted to the force transmission member 420 are balanced with each other.

Referring to FIG. 6B, the hinge base 402 may include a stopper which limits the upward and/or downward movement range D of the force transmission member 420. Excessive movement or inclination of the force transmission member 420 may be limited by the stopper.

FIG. 7A is a side view showing a hinge leaf 401 and a rotation guide 410 according to various embodiments of the disclosure.

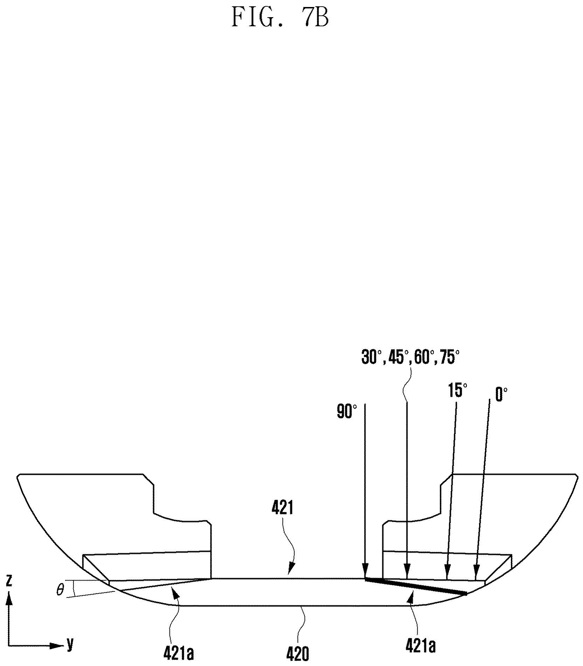

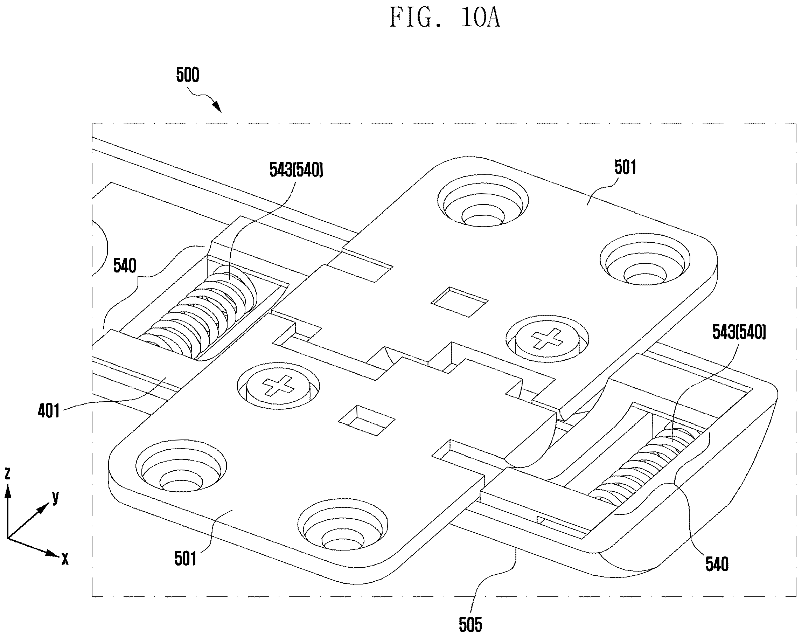

FIG. 7B is a side view showing a hinge base 402 according to various embodiments of the disclosure. It will be appreciated that the aspects of the hinge base 402 described with reference to FIG. 7A to FIG. 7B below may be combined with one or more aspects of the disclosure, including, but not limited to, aspects of the hinge 400 described with reference to FIG. 4A to FIG. 4F, aspects of the hinge actuator 440 described with reference to FIG. 5A to FIG. 5B, aspects of the hinge base 402 and force transmission member 420 described with reference to FIG. 6A to FIG. 6B, aspects of the detent operation described with reference to FIG. 8A to FIG. 8C, aspects of the force transmission member 420 described with reference to FIG. 9A to FIG. 9C, and aspects of the hinge 500 described with reference to FIG. 10A to FIG. 10B.

Referring to FIG. 7A, the rotation guide 410 may have the rotation surface 411 having a curved-surface corresponding to the rotation trajectory of the hinge leaf 401. The angle indicated on the rotation surface 411 may indicate an area of the rotation surface 411, which is in contact with the pressing surface 421 according to a rotation angle of the hinge 400. The angles as illustrated in FIG. 7A and FIG. 7B have been calculated by defining a state, in which the hinge 400 is completely closed and thus the foldable electronic device 300 is folded, as 0 degrees, and a state, in which the hinge 400 is completely open and thus the foldable electronic device 300 is unfolded, as 90 degrees. In some embodiments, the rotation surface 411 may include the cam surface 412 configured to generate detent torque which is torque in a direction opposite to the rotation direction of the rotation guide 410 at at least one rotation angle thereof. For example, multiple cam surfaces 412a and 412b may be formed on an area in which the rotation surface 411 is in contact with the pressing surface 421 in a state where the hinge 400 is completely closed (0 degrees) and/or the hinge 400 is completely open (90 degrees). The cam surface 412 may have a shape recessed with respect to the rotation trajectory thereof or may have a D-cut shape in the chord direction of an arc including the rotation trajectory. The D-cut shape may have relatively large detent torque, whereas the recessed shape may have small detent torque and a high degree of freedom of movement of the hinge 400.

Referring to FIG. 7B, the pressing surface 421 may be included therein. The pressing surface 421 may be parallel to a horizontal plane (the x-y plane), but in another embodiment, the pressing surface 421 may have both sides which are inclined to be lowered with respect to the horizontal, and the lowering angle θ may be constant or may vary depending on the position thereof. The pressing surface 421 may include an inclined area 421a to have a tangential directional component of the rotation trajectory of the rotation guide 410. The effect resulting therefrom will be described later.

FIG. 8A is a side view showing a detent operation in a closed state of a hinge 400 of the disclosure.

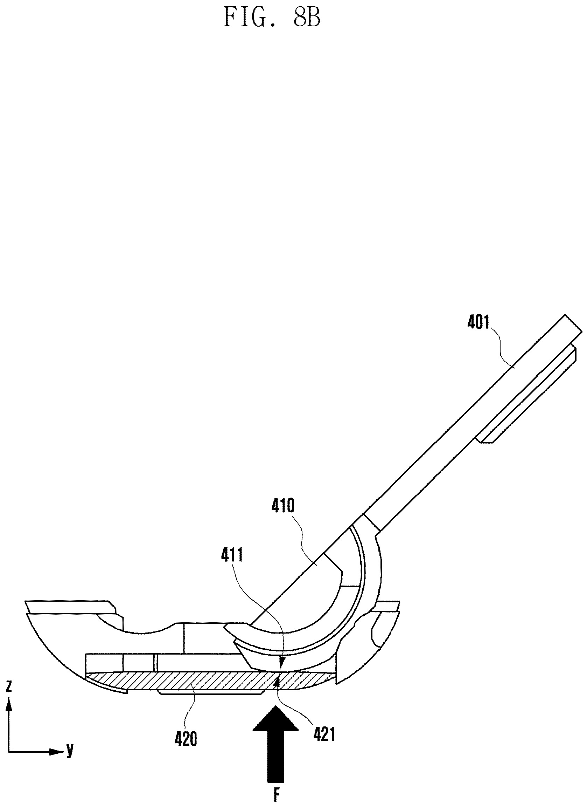

FIG. 8B is a side view showing a free stop operation of a hinge 400 of the disclosure.

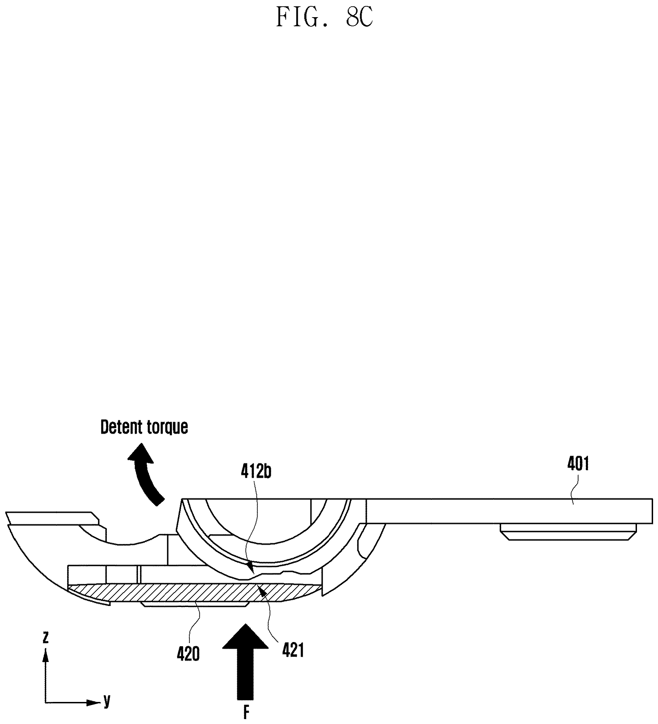

FIG. 8C is a side view showing a detent operation in an open state of a hinge 400 of the disclosure. It will be appreciated that the aspects of the detent operation described with reference to FIG. 8A to FIG. 8C below may be combined with one or more aspects of the disclosure, including, but not limited to, aspects of the hinge 400 described with reference to FIG. 4A to FIG. 4F, aspects of the hinge actuator 440 described with reference to FIG. 5A to FIG. 5B, aspects of the hinge base 402 and force transmission member 420 described with reference to FIG. 6A to FIG. 6B, aspects of the hinge leaf 401 and rotation guide 410 described with reference to FIG. 7A to FIG. 7B, aspects of the force transmission member 420 described with reference to FIG. 9A to FIG. 9C, and aspects of the hinge 500 described with reference to FIG. 10A to FIG. 10B.

Referring to FIG. 8A, in a state where the hinge 400 of the disclosure is closed, the force transmission member 420 may apply a force upward (in the z-axis direction), and the pressing surface 421 may apply a force to press the first cam surface 412a formed on the rotation surface 411. The first cam surface 412a may have a distance closer from the rotation axis of the hinge 400 compared to other areas of the rotation surface 411, and thus in case that the pressing surface 421 presses the first cam surface 412a, the force transmission member 420 may move upward. A force applied to the first cam surface 412a by the pressing surface 421 may function as detent torque for rotating the rotation guide 410. Since the partial area 421a of the pressing surface 421 is inclined toward a direction having the tangential directional component of the rotation trajectory of the rotation surface 411, the tangential directional component among components of the force applied to the first cam surface 412a by the pressing surface 421 increases, and thus detent torque applied to the rotation guide 410 may increase. Due to the detent torque, since torque to close the hinge 400 is generated in case that an angle of the hinge 400 approaches the closed angle, the torque may provide tactile feedback to a user in case that the user folds the foldable electronic device 300, thereby facilitating the folding operation and thus improving a user experience of the foldable electronic device 300.

Referring to FIG. 8B, in a state where the hinge 400 of the disclosure is partially open with an arbitrary rotation angle, the pressing surface 421 may press the rotation surface 411 to apply a frictional force to the rotation guide 410. Due to frictional force, since a free stop function, which allows the rotation of the hinge 400 to be stopped at an arbitrary rotation angle, is implemented, the foldable electronic device 300 may be folded and used in various postures so that user convenience is improved.

Referring to FIG. 8C, in a state where the hinge 400 of the disclosure is open, the pressing surface 421 may press the second cam surface 412b. Since detent torque is generated as the second cam surface 412b is pressed, torque to unfold the foldable electronic device 300 may be generated in case that an angle of the hinge 400 approaches the completely open angle. Accordingly, the torque may provide tactile feedback to a user in case that the user unfolds the foldable electronic device 300 and may help that the foldable electronic device 300 is completely unfolded, so that a user experience is improved. The description of the detent operation of the first cam surface may apply to the detent operation of the second cam surface insofar as there is no contradiction.

FIG. 9A is a schematic view showing an operation of a force transmission member 420 of a hinge 400 according to some embodiments of the disclosure.

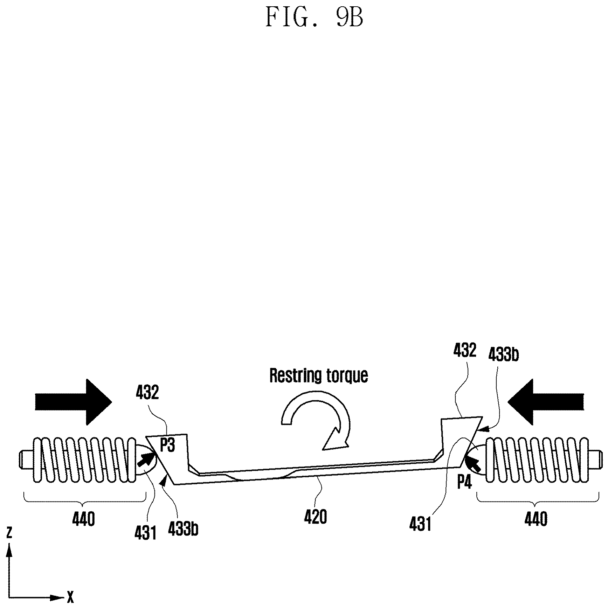

FIG. 9B is a schematic view showing an operation of a force transmission member 420 of a hinge 400 according to another embodiment of the disclosure.

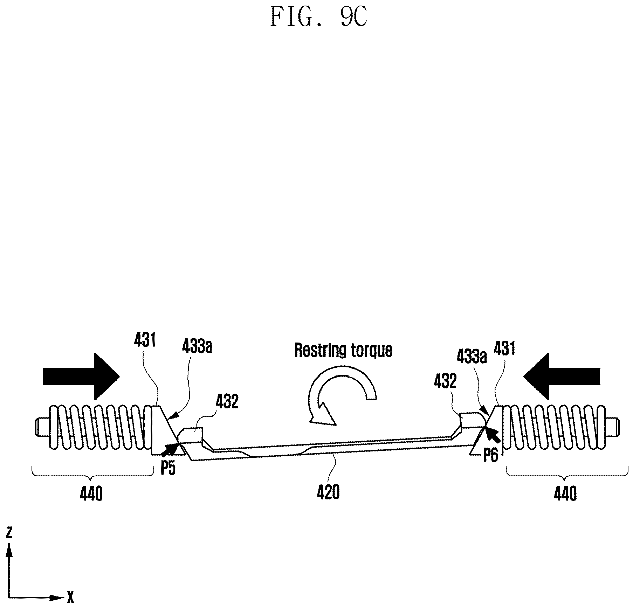

FIG. 9C is a schematic view showing an operation of a force transmission member 420 of a hinge 400 according to another embodiment of the disclosure. It will be appreciated that the aspects of the force transmission member 420 described with reference to FIG. 9A to FIG. 9C below may be combined with one or more aspects of the disclosure, including, but not limited to, aspects of the hinge 400 described with reference to FIG. 4A to FIG. 4F, aspects of the hinge actuator 440 described with reference to FIG. 5A to FIG. 5B, aspects of the hinge base 402 and force transmission member 420 described with reference to FIG. 6A to FIG. 6B, aspects of the hinge leaf 401 and rotation guide 410 described with reference to FIG. 7A to FIG. 7B, aspects of the detent operation described with reference to FIG. 8A to FIG. 8C, and aspects of the hinge 500 described with reference to FIG. 10A to FIG. 10B.

Referring to FIG. 9A to FIG. 9C, in various embodiments of the disclosure, in case that there is an error in synchronization between the rotational motions of the multiple rotation guides 410, the force transmission member 420 may be inclined with respect to a horizontal line (the y-axis direction) since the multiple rotation guides 410 are rotated with different angles.

Referring to FIG. 9A, in some embodiments, first sliding members each may include a first inclined surface 433a and second sliding members each may include a second inclined surface 433b, and in case that the force transmission member 420 maintains the horizontal (the xy plane) when the second inclined surface and the first inclined surface 433a slide, the first inclined surface 433a and the second inclined surface 433b may maintain a surface contact. However, in case that the force transmission member 420 is tilted, the surface contact between the first inclined surface 433a and the second inclined surface 433b may be converted into a point contact, and thus contact points P1 and P2, in which the second sliding members positioned at opposite ends of the force transmission member 420 are in contact with the first sliding members, may be different from each other so that a couple of forces is generated with respect to the force transmission member 420. The couple of forces may generate restoring torque for rotating the force transmission member 420 in a direction opposite to the direction in which the force transmission member 420 is tilted. The restoring torque may generate a difference in detent torque applied to the multiple rotation guides 410 in contact with the force transmission member 420, and may move the multiple rotation guides 410 in a direction in which a synchronization error in rotation angles between the multiple rotation guides 410 is reduced. Therefore, the occurrence of error in folding angles between the multiple sub-enclosures 301a and 301b of the foldable enclosure 301 may be reduced.

Referring to FIG. 9B, in another embodiment, second sliding members each may include an inclined surface 433, and first sliding members each may have the shape of a curved-surface (for example, a spherical surface, an ellipsoidal surface, or a cylindrical surface) in point or line contact with the inclined surface 433. Due to the first sliding members having the shape of a curved-surface which is in point contact and line contact with the inclined surface 433 of each of the second sliding members, the position difference in contact points P3 and P4 in which the second sliding members of opposite ends of the force transmission member 420 are contact with the first sliding members may be reduced compared to the position difference between the contact points P1 and P2 of the embodiment as illustrated in FIG. 9A. Accordingly, the above-described couple of forces and the resulting restoring torque may also be reduced. Therefore, an operation noise of the hinge 400 or damage between components of the hinge 400 caused by the restoring torque excessively applied thereto may be prevented, so that the lifespan of the foldable electronic device 300 is increased and a user experience is improved. Through adjustment of parameters such as the radius of curvature and/or the size of the curved-surface of the first sliding members, the magnitude of the restoring torque may be adjusted to an optimal level in order to increase the lifespan of the foldable electronic device 300 and improve the user experience thereof.

Referring to FIG. 9C, in another embodiment, first sliding members each may include an inclined surface 433, and the second sliding members each may have the shape of a curved-surface (for example, a spherical surface, an ellipsoidal surface, or a cylindrical surface) in point or line contact with the inclined surface 433. Due to the second sliding members having the shape of a curved-surface which is in point contact and line contact with the inclined surface 433 of each of the first sliding members, the position difference in contact points P5 and P6 in which the second sliding members of opposite ends of the force transmission member 420 are contact with the first sliding members may be generated opposite to the position difference between the contact points P1 and P2 and between the contact points P3 and P4 of the embodiments as illustrated in FIG. 9A and FIG. 9B. Therefore, the couple of forces generated in the embodiment of FIG. 9C may generate torque in a direction in which the tilt of the force transmission member 420 is increased. Therefore, it may prevent friction by the restoring torque generated at the time of a synchronization error thereof so that the operation flexibility of the hinge 400 is maximized.

FIG. 10A is a perspective view showing a hinge 500 according to another embodiment of the disclosure.

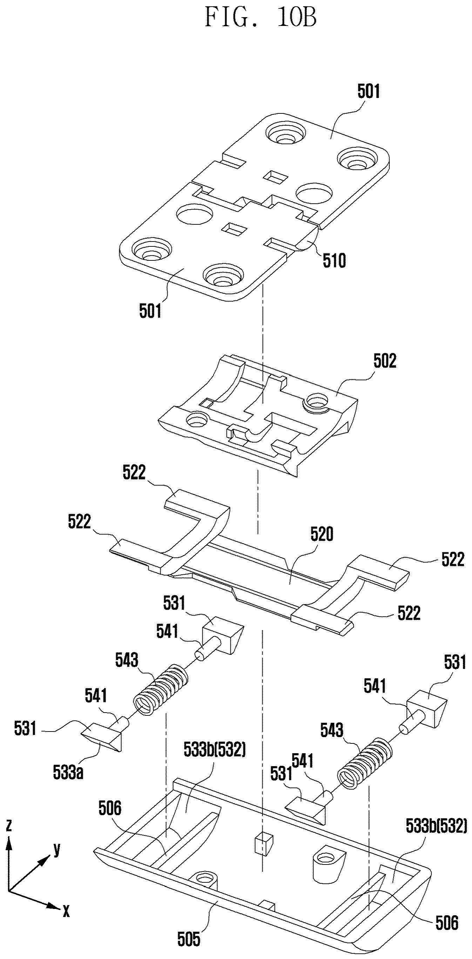

FIG. 10B is an exploded perspective view of a hinge 500 according to another embodiment of the disclosure. It will be appreciated that the aspects of the hinge 500 described with reference to FIG. 10A to FIG. 10B below may be combined with one or more aspects of the disclosure, including, but not limited to, aspects of the hinge 400 described with reference to FIG. 4A to FIG. 4F insofar as there is no contradiction, aspects of the hinge leaf 401 and rotation guide 410 described with reference to FIG. 7A to FIG. 7B, and aspects of the detent operation described with reference to FIG. 8A to FIG. 8C.

Referring to FIG. 10A and FIG. 10B, a hinge 500 according to another embodiment of the disclosure may include multiple hinge leaves 501, multiple rotation guides 510, a hinge base 502, a force transmission member 520, a force diverting part, a hinge actuator 540, and a hinge housing 505. The description of the hinge 400 as illustrated in FIG. 4A to FIG. 4F may apply to the hinge leaves 501, the rotation guides 510, and the hinge base 502 insofar as there is no contradiction.

The hinge actuator 540 may include a spring 543 and a pusher 541 positioned at the end of the spring 543 and operated by the spring 543, and a first slider 531 may be formed at the end of the pusher 541. The hinge actuator 540 may be positioned below (the - z direction) a cantilever of the force transmission member 520 to be described later. The upper surface of the pusher 541 may be in contact with the lower surface of the force transmission member 520. In some embodiments, the hinge actuator 540 may be oriented in a direction (for example, the x-axis direction) substantially parallel to a pressing surface thereof and substantially perpendicular to the rotation direction of an axis of the hinge 500. Accordingly, the size of the hinge 500 with respect to the axial direction (the y-axis direction) of the hinge 500 may be reduced.

The force transmission member 520 may include the pressing surface for pressing rotation surfaces of the rotation guides 510 from therebelow and a cantilever of which the lower surface is in contact with the upper surface of the pusher 541 and which receives a force applied upward (the z-axis direction) by the pusher 541.

The hinge housing 505 may be a member for at least partially surrounding the hinge actuator 540 and the force transmission member 520. In some embodiments, the hinge housing 505 may include a spring guide 506 for guiding the spring 543 of the hinge actuator 540.

The force diverting part may include a first slider 531 formed at the end of the hinge actuator 540 and a second slider 532 formed in an area of the inner surface of the housing, which is in contact with the first slider 531. At least one of the first slider 531 and the second slider 532 may include an inclined surface, and the first slider 531 may be in slidable contact with respect to the second slider 532. For example, the first slider 531 may include a first inclined surface 533a, and the second slider 532 may include a second inclined surface 533b in contact with the first inclined surface 533a.

In case that the pusher 541 is pressed by the elastic force of the spring 543, the first slider 531 slides on the second inclined surface 533b, and thus the pusher 541 may move in a direction including a component (a component of the z-axis) of the direction in which the pressing surface is pressed. Due to the movement of the pusher 541, the force transmission member 520 may press the pressing surface onto the rotation surfaces of the rotation guides 510. Therefore, a frictional force and detent torque may be applied to the rotation guides 510.

It will be appreciated that one or more embodiments of the disclosure may be in accordance with one or more of the following paragraphs:

According to various embodiments of the disclosure, there is provided a foldable electronic device comprising a foldable enclosure which comprises multiple sub-enclosures and is foldable and unfoldable and a hinge configured to rotatably connect the multiple sub-enclosures around at least one rotation axis, wherein the hinge comprises multiple hinge leaves respectively coupled to ends of the multiple sub-enclosures and configured to rotate during folding and unfolding operations of the foldable enclosure, a rotation guide which is formed on each of the hinge leaves and comprises a rotation surface having a curved-surface of a shape corresponding to a rotation trajectory of the hinge leaves, a force transmission member having a pressing surface configured to press against the rotation surface of the rotation guide, a force diverting part configured to convert a force having a directional component parallel to the pressing surface to a force having a directional component perpendicular to the pressing surface, to change the direction in which the force is applied, thereby pressing the force transmission member against the curved-surface of the rotation guide, and a hinge actuator configured to apply a force to the force diverting part in a direction having a directional component parallel to the pressing surface.

In various embodiments, the rotation surface of the rotation guide may comprise a cam surface which is an area recessed based on the rotation trajectory.

In various embodiments, the cam surface may be formed on an area of the rotation surface which is configured to contact with the pressing surface in a state where the foldable enclosure is folded.

In various embodiments, the cam surface may be formed on an area of the rotation surface which is configured to contact with the pressing surface in a state where the foldable enclosure is unfolded.

In various embodiments, an area of the pressing surface, which comprises an area configured to contact with the rotation surface, may have an inclined area oriented in a direction having a tangential directional component of the rotation trajectory.

In various embodiments, the force diverting part may comprise: a first slider coupled to the hinge actuator, and a second slider coupled to the force transmission member and configured to slidably contact against the first slider. At least one of the first slider and the second slider may comprise an inclined surface inclined with respect to the pressing direction of the pressing surface.

In various embodiments, the hinge actuator may be configured to press the second slider, via the first slider, in a direction having a directional component parallel to the rotation axis of the hinge, and the second slider may be configured to slide against the first slider along the inclined surface and thus to move such that the pressing surface of the force transmission member is pressed against the rotation guide by the hinge actuator.

In various embodiments, the first slider and the second slider may comprise a first inclined surface and a second inclined surface which slide in contact with each other.

the first slider comprises the inclined surface and the second slider comprises a curved-surface part slidably in contact against the inclined surface.

In various embodiments, the second slider may comprise the inclined surface and the first slider may comprise a curved-surface part slidably in contact against the inclined surface.

In various embodiments, the foldable electronic device may comprise a hinge housing configured to at least partially surround and support the hinge actuator and the force transmission member, and the force diverting part may comprise: a first slider positioned at the end of the hinge actuator and positioned below the force transmission member, and a second slider which is formed on an area configured to contact with the first slider in the inside of the hinge housing and to allow sliding of the first slider, and at least one of the first slider and the second slider may comprise an inclined surface inclined with respect to the pressing direction of the pressing surface.

In various embodiments, the hinge actuator may be oriented in a direction having a directional component perpendicular to the rotation axis of the hinge and configured to press the first slider against the second slider, and the first slider may be configured to slide against the second slider such that the force transmission member moves to press the pressing surface against the rotation guide.

A hinge device, according to is a hinge device for a foldable electronic device, the foldable electronic device comprising a foldable enclosure which comprises multiple sub-enclosures and is foldable and unfoldable and a hinge configured to rotatably connect the multiple sub-enclosures around at least one axis of rotation, and comprising: multiple hinge leaves respectively coupled to ends of the multiple sub-enclosures and configured to rotate during folding and unfolding operations of the foldable enclosure, a rotation guide which is formed on each of the hinge leaves and comprises a rotation surface having a curved-surface of a shape corresponding to a rotation trajectory of the hinge leaves, a force transmission member having a pressing surface configured to press against the rotation surface of the rotation guide, a force diverting part configured to convert a force having a directional component parallel to the pressing surface to a force having a directional component perpendicular to the pressing surface, to change the direction in which the force is applied, thereby pressing the force transmission member against the curved-surface of the rotation guide, and a hinge actuator configured to press the force diverting part in a direction having a directional component parallel to the pressing surface.

In various embodiments, the rotation surface of the rotation guide may comprise a cam surface which is an area recessed based on the rotation trajectory.

In various embodiments, the cam surface may be formed on an area of the rotation surface which is configured to contact with the pressing surface in a state where the foldable enclosure is folded.

In various embodiments, the cam surface may be formed on an area of the rotation surface which is configured to contact with the pressing surface in a state where the foldable enclosure is unfolded.

In various embodiments, an area of the pressing surface, which comprises an area configured to contact with the rotation surface, may have an inclined area oriented in a direction having a tangential directional component of the rotation trajectory.

In various embodiments, the force diverting part may comprise: a first slider coupled to the hinge actuator, and a second slider coupled to the force transmission member and configured to slidably contact against the first slider, and at least one of the first slider and the second slider may comprise an inclined surface inclined with respect to the pressing direction of the pressing surface.

In various embodiments, the hinge actuator may be configured to press the second slider, via the first slider, in a direction having a directional component parallel to the rotation axis of the hinge, and the second slider may be configured to slide against the first slider along the inclined surface such that the pressing surface of the force transmission member is moved to press against the rotation guide by the hinge actuator.

In various embodiments, the hinge device may further comprise a hinge housing configured to at least partially surround and support the hinge actuator and the force transmission member, wherein the force diverting part may comprise: a first slider positioned at the end of the hinge actuator and positioned below the force transmission member, and a second slider which is formed on an area configured to contact with the first slider in the inside of the hinge housing and to allow sliding of the first slider, and at least one of the first slider and the second slider may comprise an inclined surface inclined with respect to the pressing direction of the pressing surface.

Embodiments disclosed in the document including the specification and the drawings are merely specific examples presented to easily describe the technical content according to the embodiments disclosed in the document and to help understanding of the embodiments disclosed in the document, and are not intended to limit the scope of embodiments disclosed in the document. Accordingly, in connection with the scope of various embodiments disclosed in the document, it should be interpreted that not only embodiments disclosed herein but also all changed or modified forms derived based on the technical idea of various embodiments disclosed in the document are included in the scope of various embodiments disclosed in the document.

All of the individual features disclosed in this specification (including any accompanying claims, abstract and drawings), and/or all of the individual operations (steps) of any method or process disclosed herein, may be combined in any combination, with the possible exception of any combinations where at least some of such features and/or steps are mutually exclusive as would be understood by the skilled person. **In** other words, combinations of the embodiments and/or examples disclosed herein are envisaged and are therefore included within the scope of the disclosure. No subject-matter can be seen to be added to the application if features from multiple different embodiments/examples are combined (including cases when other features from such multiple different embodiments are omitted from the combination), because every combination should be regarded as disclosed within the scope of the specification.

## Claims

1. A foldable electronic device (300) comprising:
a foldable enclosure (301) comprising multiple sub-enclosures (301a, 301b) and being able to be folded or unfolded; and
a hinge (400) configured to rotatably connect the multiple sub-enclosures (301a, 301b) to each other around at least one rotation axis,
wherein the hinge (400) comprises:
multiple hinge leaves (401) respectively coupled to ends of the multiple sub-enclosures (301a, 301b) and configured to rotate during folding and unfolding operations of the foldable enclosure (301);
a rotation guide (410) which is formed on each of the hinge leaves (401) and comprises a rotation surface (411) having a curved-surface of a shape corresponding to a rotation trajectory of the hinge leaves (401);
a force transmission member (420) having a pressing surface (421) configured to press against the rotation surface (411) of the rotation guide (410);
a force diverting part (430) configured to convert a force having a directional component parallel to the pressing surface (421) to a force having a directional component perpendicular to the pressing surface (421), to change the direction in which the force is applied, thereby pressing the force transmission member (420) against the curved-surface of the rotation guide (410); and
a hinge actuator (440) configured to apply a force to the force diverting part (430) in a direction having a directional component parallel to the pressing surface (421).

2. The foldable electronic device (300) of claim 1, wherein the rotation surface (411) of the rotation guide (410) comprises a cam surface (412) which is an area recessed based on the rotation trajectory.

3. The foldable electronic device (300) of claim 2, wherein an area of the pressing surface (421), which comprises an area configured to contact with the rotation surface (411), has an inclined area (421a) oriented in a direction having a tangential directional component of the rotation trajectory.

4. The foldable electronic device (300) of claim 1, wherein the force diverting part (430) comprises:
a first slider (431) coupled to the hinge actuator (440); and
a second slider (432) coupled to the force transmission member (420) and configured to slidably contact against the first slider (431), and
wherein at least one of the first slider (431) and the second slider (432) comprises an inclined surface (433) inclined with respect to the pressing direction of the pressing surface (421).

5. The foldable electronic device (300) of claim 4, wherein the hinge actuator (440) is configured to press the second slider (432), via the first slider (431), in a direction having a directional component parallel to the rotation axis of the hinge (400), and
wherein the second slider (432) is configured to slide against the first slider (431) along the inclined surface (433) and thus to move such that the pressing surface (421) of the force transmission member (420) is pressed against the rotation guide (410) by the hinge actuator (440).

6. The foldable electronic device (300) of claim 4, wherein the first slider (431) and the second slider (432) comprise a first inclined surface (433a) and a second inclined surface (433b) which slide in contact with each other.

7. The foldable electronic device (300) of claim 4, wherein the first slider (431) comprises the inclined surface (433) and the second slider (432) comprises a curved-surface part slidably in contact against the inclined surface (433).

8. The foldable electronic device (300) of claim 4, wherein the second slider (432) comprises the inclined surface (433) and the first slider (431) comprises a curved-surface part slidably in contact against the inclined surface (433).

9. The foldable electronic device (300) of claim 1, comprising a hinge housing (505) configured to at least partially surround and support the hinge actuator (440) and the force transmission member (420),
wherein the force diverting part (430) comprises:
a first slider (431) positioned at the end of the hinge actuator (440) and positioned below the force transmission member (420); and
a second slider (432) which is formed on an area configured to contact with the first slider (431) in the inside of the hinge housing and to allow sliding of the first slider (431),
wherein at least one of the first slider (431) and the second slider (432) comprises an inclined surface (433) inclined with respect to the pressing direction of the pressing surface (421), and
wherein the hinge actuator (440) is oriented in a direction having a directional component perpendicular to the rotation axis of the hinge (400) and configured to press the first slider (431) against the second slider (432), and wherein the first slider (431) is configured to slide against the second slider (432) such that the force transmission member (420) moves to press the pressing surface (421) against the rotation guide (410).

10. A hinge device for a foldable electronic device (300) comprising a foldable enclosure (301) which comprises multiple sub-enclosures (301a, 301b) and is able to be folded and unfolded and a hinge (400) configured to rotatably connect the multiple sub-enclosures (301a, 301b) to each other around at least one axis of rotation, the hinge device comprising:
multiple hinge leaves (401) respectively coupled to ends of the multiple sub-enclosures (301a, 301b) and configured to rotate during folding and unfolding operations of the foldable enclosure (301);
a rotation guide (410) which is formed on each of the hinge leaves (401) and comprises a rotation surface (411) having a curved-surface of a shape corresponding to a rotation trajectory of the hinge leaves (401);
a force transmission member (420) having a pressing surface (421) configured to press against the rotation surface (411) of the rotation guide (410);
a force diverting part (430) configured to convert a force having a directional component parallel to the pressing surface (421) to a force having a directional component perpendicular to the pressing surface (421), to change the direction in which the force is applied, thereby pressing the force transmission member (420) against the curved-surface of the rotation guide (410); and
a hinge actuator (440) configured to press the force diverting part (430) in a direction having a directional component parallel to the pressing surface (421).

11. The hinge device of claim 10, wherein the rotation surface (411) of the rotation guide (410) comprises a cam surface (412) which is an area recessed based on the rotation trajectory.

12. The hinge device of claim 11, wherein an area of the pressing surface (421), which comprises an area configured to contact with the rotation surface (411), has an inclined area (421a) oriented in a direction having a tangential directional component of the rotation trajectory.

13. The hinge device of claim 10, wherein the force diverting part (430) comprises:
a first slider (431) coupled to the hinge actuator (440); and
a second slider (432) coupled to the force transmission member (420) and configured to slidably contact against the first slider (431), and
wherein at least one of the first slider (431) and the second slider (432) comprises an inclined surface (433) inclined with respect to the pressing direction of the pressing surface (421).

14. The hinge device of claim 10, wherein the hinge actuator (440) is configured to press the second slider (432), via the first slider (431), in a direction having a directional component parallel to the rotation axis of the hinge, and
wherein the second slider (432) is configured to slide against the first slider (431) along the inclined surface (433) such that the pressing surface (421) of the force transmission member (420) is moved to press against the rotation guide (410) by the hinge actuator (440).

15. The hinge device of claim 10, further comprising a hinge housing (505) configured to at least partially surround and support the hinge actuator (440) and the force transmission member (420),
wherein the force diverting part (430) comprises:
a first slider (431) positioned at the end of the hinge actuator (440) and positioned below the force transmission member (420); and
a second slider (432) which is formed on an area configured to contact with the first slider (431) in the inside of the hinge housing and to allow sliding of the first slider (431), and
wherein at least one of the first slider (431) and the second slider (432) comprises an inclined surface (433) inclined with respect to the pressing direction of the pressing surface (421).

## Patentansprüche

1. Klappbare elektronische Vorrichtung (300), umfassend:
eine klappbare Hülle (301), die mehrere Unterhüllen (301a, 301b) umfasst und zusammengeklappt oder auseinandergeklappt werden kann; und
ein Scharnier (400), das dazu konfiguriert ist, die mehreren Unterhüllen (301a, 301b) um mindestens eine Drehachse drehbar miteinander zu verbinden,
wobei das Scharnier (400) umfasst:
mehrere Scharnierblätter (401), die jeweils mit Enden der mehreren Unterhüllen (301a, 301b) gekoppelt sind und dazu konfiguriert sind, sich während der Zusammenklapp- und Auseinanderklappvorgänge der klappbaren Hülle (301) zu drehen;
eine Drehführung (410), die an jedem der Scharnierblätter (401) ausgebildet ist und eine Drehfläche (411) mit einer gekrümmten Oberfläche einer Form umfasst, die einer Drehbahn der Scharnierblätter (401) entspricht;
ein Kraftübertragungselement (420) mit einer Druckfläche (421), die dazu konfiguriert ist, gegen die Drehfläche (411) der Drehführung (410) zu drücken;
einen Kraftumleitungsteil (430), das dazu konfiguriert ist, eine Kraft mit einer Richtungskomponente parallel zur Druckfläche (421) in eine Kraft mit einer Richtungskomponente senkrecht zur Druckfläche (421) umzuwandeln, um die Richtung zu ändern, in der die Kraft ausgeübt wird, wodurch das Kraftübertragungselement (420) gegen die gekrümmte Oberfläche der Drehführung (410) gedrückt wird; und
einen Scharnieraktuator (440), der dazu konfiguriert ist, eine Kraft auf den Kraftumleitungsteil (430) in einer Richtung auszuüben, die eine Richtungskomponente parallel zur Druckfläche (421) aufweist.

2. Klappbare elektronische Vorrichtung (300) nach Anspruch 1, wobei die Drehfläche (411) der Drehführung (410) eine Nockenfläche (412) umfasst, die ein Bereich ist, der basierend auf der Drehbahn vertieft ist.

3. Klappbare elektronische Vorrichtung (300) nach Anspruch 2, wobei ein Bereich der Druckfläche (421), der einen Bereich umfasst, der dazu konfiguriert ist, mit der Drehfläche (411) in Kontakt zu stehen, einen geneigten Bereich (421a) aufweist, der in eine Richtung ausgerichtet ist, die eine tangentiale Richtungskomponente der Drehbahn aufweist.

4. Klappbare elektronische Vorrichtung (300) nach Anspruch 1, wobei der Kraftumleitungsteil (430) umfasst:
einen ersten Schieber (431), der mit dem Scharnieraktuator (440) gekoppelt ist; und
einen zweiten Schieber (432), der mit dem Kraftübertragungselement (420) gekoppelt ist und dazu konfiguriert ist, gleitend gegen den ersten Schieber (431) in Kontakt zu stehen, und
wobei mindestens einer von dem ersten Schieber (431) und dem zweiten Schieber (432) eine geneigte Oberfläche (433) umfasst, die in Bezug auf die Druckrichtung der Druckfläche (421) geneigt ist.

5. Klappbare elektronische Vorrichtung (300) nach Anspruch 4, wobei der Scharnieraktuator (440) dazu konfiguriert ist, den zweiten Schieber (432) über den ersten Schieber (431) in eine Richtung zu drücken, die eine Richtungskomponente parallel zur Drehachse des Scharniers (400) aufweist, und
wobei der zweite Schieber (432) dazu konfiguriert ist, entlang der geneigten Oberfläche (433) gegen den ersten Schieber (431) zu gleiten und sich somit derart zu bewegen, dass die Druckfläche (421) des Kraftübertragungselements (420) durch den Scharnieraktuator (440) gegen die Drehführung (410) gedrückt wird.

6. Klappbare elektronische Vorrichtung (300) nach Anspruch 4, wobei der erste Schieber (431) und der
zweite Schieber (432) eine erste geneigte Oberfläche (433a) und eine zweite geneigte Oberfläche (433b) umfassen, die in Kontakt miteinander gleiten.

7. Klappbare elektronische Vorrichtung (300) nach Anspruch 4, wobei der erste Schieber (431) die geneigte Oberfläche (433) umfasst und der zweite Schieber (432) einen Teil mit gekrümmter Oberfläche umfasst, der gleitend mit der geneigten Oberfläche (433) in Kontakt steht.

8. Klappbare elektronische Vorrichtung (300) nach Anspruch 4, wobei der zweite Schieber (432) die geneigte Oberfläche (433) umfasst und der erste Schieber (431) einen Teil mit gekrümmter Oberfläche umfasst, der gleitend mit der geneigten Oberfläche (433) in Kontakt steht.

9. Klappbare elektronische Vorrichtung (300) nach Anspruch 1, umfassend ein Scharniergehäuse (505), das dazu konfiguriert ist, den Scharnieraktuator (440) und das Kraftübertragungselement (420) mindestens teilweise zu umgeben und zu stützen,
wobei der Kraftumleitungsteil (430) umfasst:
einen ersten Schieber (431), der am Ende des Scharnieraktuators (440) positioniert ist und unterhalb des Kraftübertragungselements (420) positioniert ist; und
einen zweiten Schieber (432), der an einem Bereich ausgebildet ist, der dazu konfiguriert ist, mit dem ersten Schieber (431) im Inneren des Scharniergehäuses in Kontakt zu stehen und ein Gleiten des ersten Schiebers (431) zu ermöglichen,
wobei mindestens einer von dem ersten Schieber (431) und dem zweiten Schieber (432) eine geneigte Oberfläche (433) umfasst, die in Bezug auf die Druckrichtung der Druckfläche (421) geneigt ist, und
wobei der Scharnieraktuator (440) in eine Richtung ausgerichtet ist, die eine Richtungskomponente senkrecht zur Drehachse des Scharniers (400) aufweist, und dazu konfiguriert ist, den ersten Schieber (431) gegen den zweiten Schieber (432) zu drücken, und wobei der erste Schieber (431) dazu konfiguriert ist,
gegen den zweiten Schieber (432) derart zu gleiten, dass sich das Kraftübertragungselement (420) bewegt, um die Druckfläche (421) gegen die Drehführung (410) zu drücken.

10. Scharniervorrichtung für eine klappbare elektronische Vorrichtung (300) umfassend eine klappbare Hülle (301), die mehrere Unterhüllen (301a, 301b) umfasst und zusammengeklappt und auseinandergeklappt werden kann, und ein Scharnier (400), das dazu konfiguriert ist, die mehreren Unterhüllen (301a, 301b) um mindestens eine Drehachse drehbar miteinander zu verbinden, wobei die Scharniervorrichtung umfasst:
mehrere Scharnierblätter (401), die jeweils mit Enden der mehreren Unterhüllen (301a, 301b) gekoppelt sind und dazu konfiguriert sind, sich während der Zusammenklapp- und Auseinanderklappvorgänge der klappbaren Hülle (301) zu drehen;
eine Drehführung (410), die an jedem der Scharnierblätter (401) ausgebildet ist und eine Drehfläche (411) mit einer gekrümmten Oberfläche einer Form umfasst, die einer Drehbahn der Scharnierblätter (401) entspricht;
ein Kraftübertragungselement (420) mit einer Druckfläche (421), die dazu konfiguriert ist, gegen die Drehfläche (411) der Drehführung (410) zu drücken;
einen Kraftumleitungsteil (430), das dazu konfiguriert ist, eine Kraft mit einer Richtungskomponente parallel zur Druckfläche (421) in eine Kraft mit einer Richtungskomponente senkrecht zur Druckfläche (421) umzuwandeln, um die Richtung zu ändern, in der die Kraft ausgeübt wird, wodurch das Kraftübertragungselement (420) gegen die gekrümmte Oberfläche der Drehführung (410) gedrückt wird; und
einen Scharnieraktuator (440), der dazu konfiguriert ist, den Kraftumleitungsteil (430) in eine Richtung zu drücken, die eine Richtungskomponente parallel zur Druckfläche (421) aufweist.

11. Scharniervorrichtung nach Anspruch 10, wobei die Drehfläche (411) der Drehführung (410) eine Nockenfläche (412) umfasst, die ein Bereich ist, der basierend auf der Drehbahn vertieft ist.

12. Scharniervorrichtung nach Anspruch 11, wobei ein Bereich der Druckfläche (421), der einen Bereich umfasst, der dazu konfiguriert ist, mit der Drehfläche (411) in Kontakt zu stehen, einen geneigten Bereich (421a) aufweist, der in eine Richtung ausgerichtet ist, die eine tangentiale Richtungskomponente der Drehbahn aufweist.

13. Scharniervorrichtung nach Anspruch 10, wobei der Kraftumleitungsteil (430) umfasst:
einen ersten Schieber (431), der mit dem Scharnieraktuator (440) gekoppelt ist; und
einen zweiten Schieber (432), der mit dem Kraftübertragungselement (420) gekoppelt ist und dazu konfiguriert ist, gleitend gegen den ersten Schieber (431) in Kontakt zu stehen, und
wobei mindestens einer von dem ersten Schieber (431) und dem zweiten Schieber (432) eine geneigte Oberfläche (433) umfasst, die in Bezug auf die Druckrichtung der Druckfläche (421) geneigt ist.

14. Scharniervorrichtung nach Anspruch 10, wobei der Scharnieraktuator (440) dazu konfiguriert ist, den zweiten Schieber (432) über den ersten Schieber (431) in eine Richtung zu drücken, die eine Richtungskomponente parallel zur Drehachse des Scharniers aufweist, und
wobei der zweite Schieber (432) dazu konfiguriert ist, entlang der geneigten Oberfläche (433) gegen den ersten Schieber (431) derart zu gleiten, dass die Druckfläche (421) des Kraftübertragungselements (420) so bewegt wird, dass sie durch den Scharnieraktuator (440) gegen die Drehführung (410) gedrückt wird.

15. Scharniervorrichtung nach Anspruch 10, ferner umfassend ein Scharniergehäuse (505), das dazu konfiguriert ist, den Scharnieraktuator (440) und das Kraftübertragungselement (420) mindestens teilweise zu umgeben und zu stützen,
wobei der Kraftumleitungsteil (430) umfasst:
einen ersten Schieber (431), der am Ende des Scharnieraktuators (440) positioniert ist und unterhalb des Kraftübertragungselements (420) positioniert ist; und
einen zweiten Schieber (432), der an einem Bereich ausgebildet ist, der dazu konfiguriert ist, mit dem ersten Schieber (431) im Inneren des Scharniergehäuses in Kontakt zu stehen und ein Gleiten des ersten Schiebers (431) zu ermöglichen, und wobei mindestens einer von dem ersten Schieber (431) und dem zweiten Schieber (432) eine geneigte Oberfläche (433) umfasst, die in Bezug auf die Druckrichtung der Druckfläche (421) geneigt ist.

## Revendications

1. Dispositif électronique pliable (300) comprenant :
une enceinte pliable (301) comprenant de multiples sous-enceintes (301a, 301b) et pouvant être pliée ou dépliée ; et
une charnière (400) conçue pour relier de manière rotative les multiples sous-enceintes (301a, 301b) les unes aux autres autour d'au moins un axe de rotation,
dans lequel la charnière (400) comprend :
plusieurs feuilles de charnière (401) couplées respectivement à des extrémités des multiples sous-enceintes (301a, 301b) et conçues pour tourner pendant des opérations de pliage et de dépliage de l'enceinte pliable (301) ;
un guide de rotation (410) qui est formé sur chacune des feuilles de charnière (401) et comprend une surface de rotation (411) comportant une surface incurvée d'une forme correspondant à une trajectoire de rotation des feuilles de charnière (401) ;
un élément de transmission de force (420) comportant une surface de pression (421) conçue pour presser contre la surface de rotation (411) du guide de rotation (410) ;
une partie de déviation de force (430) conçue pour convertir une force comportant une composante directionnelle parallèle à la surface de pression (421) en une force comportant une composante directionnelle perpendiculaire à la surface de pression (421), pour changer la direction dans laquelle la force est appliquée, pressant ainsi l'élément de transmission de force (420) contre la surface incurvée du guide de rotation (410) ; et
un actionneur de charnière (440) conçu pour appliquer une force à la partie de déviation de force (430) dans une direction comportant une composante directionnelle parallèle à la surface de pression (421).

2. Dispositif électronique pliable (300) de la revendication 1, dans lequel la surface de rotation (411) du guide de rotation (410) comprend une surface de came (412) qui est une zone en retrait en fonction de la trajectoire de rotation.

3. Dispositif électronique pliable (300) de la revendication 2, dans lequel une zone de la surface de pression (421), qui comprend une zone conçue pour entrer en contact avec la surface de rotation (411), comporte une zone inclinée (421a) orientée dans une direction comportant une composante directionnelle tangentielle de la trajectoire de rotation.

4. Dispositif électronique pliable (300) de la revendication 1, dans lequel la partie de déviation de force (430) comprend :
une première glissière (431) couplée à l'actionneur de charnière (440) ; et
une seconde glissière (432) couplée à l'élément de transmission de force (420) et conçue pour entrer en contact de manière coulissante contre la première glissière (431), et
dans lequel au moins l'une de la première glissière (431) et de la seconde glissière (432) comprend une surface inclinée (433) inclinée par rapport à la direction de pression de la surface de pression (421).

5. Dispositif électronique pliable (300) de la revendication 4, dans lequel l'actionneur de charnière (440) est conçu pour presser la seconde glissière (432), par l'intermédiaire de la première glissière (431), dans une direction comportant une composante directionnelle parallèle à l'axe de rotation de la charnière (400), et
dans lequel la seconde glissière (432) est conçue pour coulisser contre la première glissière (431) le long de la surface inclinée (433) et ainsi se déplacer de sorte que la surface de pression (421) de l'élément de transmission de force (420) est pressée contre le guide de rotation (410) par l'actionneur de charnière (440).

6. Dispositif électronique pliable (300) de la revendication 4, dans lequel la première glissière (431) et la seconde glissière (432) comprend une première surface inclinée (433a) et une seconde surface inclinée (433b) qui glissent en contact l'une avec l'autre.

7. Dispositif électronique pliable (300) de la revendication 4, dans lequel la première glissière (431) comprend la surface inclinée (433) et la seconde glissière (432) comprend une partie de surface incurvée en contact coulissant contre la surface inclinée (433).

8. Dispositif électronique pliable (300) de la revendication 4, dans lequel la seconde glissière (432) comprend la surface inclinée (433) et la première glissière (431) comprend une partie de surface incurvée en contact coulissant contre la surface inclinée (433).

9. Dispositif électronique pliable (300) de la revendication 1, comprenant un boîtier de charnière (505) conçu pour entourer et supporter au moins partiellement l'actionneur de charnière (440) et l'élément de transmission de force (420),
dans lequel la partie de déviation de force (430) comprend :
une première glissière (431) positionnée au niveau de l'extrémité de l'actionneur de charnière (440) et positionnée sous l'élément de transmission de force (420) ; et
une seconde glissière (432) qui est formée sur une zone conçue pour entrer en contact avec la première glissière (431) à l'intérieur du boîtier de charnière et pour permettre un coulissement de la première glissière (431),
dans lequel au moins l'une de la première glissière (431) et de la seconde glissière (432) comprend une surface inclinée (433) inclinée par rapport à la direction de pression de la surface de pression (421), et
dans lequel l'actionneur de charnière (440) est orienté dans une direction comportant une composante directionnelle perpendiculaire à l'axe de rotation de la charnière (400) et conçu pour presser la première glissière (431) contre la seconde glissière (432), et dans lequel la première glissière (431) est conçue pour glisser contre la seconde glissière (432) de sorte que l'élément de transmission de force (420) se déplace pour presser la surface de pression (421) contre le guide de rotation (410).

10. Dispositif de charnière pour un dispositif électronique pliable (300) comprenant une enceinte pliable (301) qui comprend de multiples sous-enceintes (301a, 301b) et peut être pliée et dépliée et une charnière (400) conçue pour relier de manière rotative les multiples sous-enceintes (301a, 301b) les unes aux autres autour d'au moins un axe de rotation, le dispositif de charnière comprenant :
plusieurs feuilles de charnière (401) couplées respectivement à des extrémités des multiples sous-enceintes (301a, 301b) et conçues pour tourner pendant des opérations de pliage et de dépliage de l'enceinte pliable (301) ;
un guide de rotation (410) qui est formé sur chacune des feuilles de charnière (401) et comprend une surface de rotation (411) comportant une surface incurvée d'une forme correspondant à une trajectoire de rotation des feuilles de charnière (401) ;
un élément de transmission de force (420) comportant une surface de pression (421) conçue pour presser contre la surface de rotation (411) du guide de rotation (410) ;
une partie de déviation de force (430) conçue pour convertir une force comportant une composante directionnelle parallèle à la surface de pression (421) en une force comportant une composante directionnelle perpendiculaire à la surface de pression (421), pour changer la direction dans laquelle la force est appliquée, pressant ainsi l'élément de transmission de force (420) contre la surface incurvée du guide de rotation (410) ; et
un actionneur de charnière (440) conçu pour presser la partie de déviation de force (430) dans une direction comportant une composante directionnelle parallèle à la surface de pression (421).

11. Dispositif de charnière de la revendication 10, dans lequel la surface de rotation (411) du guide de rotation (410) comprend une surface de came (412) qui est une zone en retrait en fonction de la trajectoire de rotation.

12. Dispositif de charnière de la revendication 11, dans lequel une zone de la surface de pression (421), qui comprend une zone conçue pour entrer en contact avec la surface de rotation (411), comporte une zone inclinée (421a) orientée dans une direction comportant une composante directionnelle tangentielle de la trajectoire de rotation.

13. Dispositif de charnière de la revendication 10, dans lequel la partie de déviation de force (430) comprend :
une première glissière (431) couplée à l'actionneur de charnière (440) ; et
une seconde glissière (432) couplée à l'élément de transmission de force (420) et conçue pour entrer en contact de manière coulissante contre la première glissière (431), et
dans lequel au moins l'une de la première glissière (431) et de la seconde glissière (432) comprend une surface inclinée (433) inclinée par rapport à la direction de pression de la surface de pression (421).

14. Dispositif de charnière de la revendication 10, dans lequel l'actionneur de charnière (440) est conçu pour presser la seconde glissière (432), par l'intermédiaire de la première glissière (431), dans une direction comportant une composante directionnelle parallèle à l'axe de rotation de la charnière, et
dans lequel la seconde glissière (432) est conçue pour coulisser contre la première glissière (431) le long de la surface inclinée (433) de sorte que la surface de pression (421) de l'élément de transmission de force (420) est déplacé pour presser contre le guide de rotation (410) par l'actionneur de charnière (440).

15. Dispositif de charnière de la revendication 10, comprenant en outre un boîtier de charnière (505) conçu pour entourer et supporter au moins partiellement l'actionneur de charnière (440) et l'élément de transmission de force (420),
dans lequel la partie de déviation de force (430) comprend :
une première glissière (431) positionnée au niveau de l'extrémité de l'actionneur de charnière (440) et positionnée sous l'élément de transmission de force (420) ; et
une seconde glissière (432) qui est formée sur une zone conçue pour entrer en contact avec la première glissière (431) à l'intérieur du boîtier de charnière et pour permettre un coulissement de la première glissière (431), et
dans lequel au moins l'une de la première glissière (431) et de la seconde glissière (432) comprend une surface inclinée (433) inclinée par rapport à la direction de pression de la surface de pression (421).
